# EUROPEAN PATENT SPECIFICATION

(11) **EP 1 353 192 B1**
(45) Date of publication and mention of the grant of the patent: **02.12.2009**
(21) Application number: 03100618.2
(22) Date of filing: 11.03.2003
(51) Int. Cl.: G01R 33/389

(54) **Method and device for compensating for magnetic noise fields in spatial volumes, and nuclear magnetic resonance imaging apparatus.**
Verfahren und Gerät zur Kompensierung von magnetischen Rauschfeldern in räumlichen Volumina und Kernspintomograph
Méthode et appareil pour la compensation de champs magnétiques de bruit dans des volumes spatiaux, et appareil d'imagerie par résonance magnétique

(30) Priority: 09.04.2002 IT SV20020014
(43) Date of publication of application: 15.10.2003
(73) Proprietor: Esaote S.p.A., 20100 Milano (IT)
(72) Inventor: Carlini, Davide, 16100, Genova (IT); Carrozzi, Alessandro, I-19126, La Spezia (IT); Ginanneschi, Aldo, I-16159, Genova (IT); Iaia, Paolo, I-16156, Genova (IT)
(74) Representative: Karaghiosoff, Giorgio Alessandro

(56) References cited:
- EP-A- 0 445 960
- EP-A- 0 692 721
- EP-A- 0 899 576
- WO-A-92/18873
- DE-A- 19 702 831

## Description

The invention relates to a method for compensating for magnetic noise fields in spatial volumes, according to the preamble of claim 1.

In the following description and claims, "noise fields" shall be intended as magnetic field fluctuations induced in a spatial volume, particularly the imaging cavity of Magnetic Resonance imaging apparatuses, which fluctuations are caused by magnetic fields outside said spatial volume or the imaging cavity of the MRI apparatus.

Currently, the wide use of electric power causes the generation of considerable magnetic fields, which pervade the environment. These magnetic fields may have considerable strengths and affect or alter the operation of electric or electronic equipment which use magnetic fields. Such equipment may be of any type, e.g, measuring instruments, diagnostic or therapeutic imaging apparatuses, and the like.

Currently, the above noise may be caused by two types of magnetic fields, which are differentiated on the basis of frequency. A first so-called low-frequency type includes magnetic fields with frequencies ranging from less than 1Hz to a few units of Hz. These types of low-frequency noise fields are typically generated by the passage of vehicles or the like. Each vehicle generates, in first approximation, a magnetic dipole with a predetermined strength and a predetermined position and the dipoles are oriented in the direction of the earth's magnetic field flow lines.

A second type includes noise fields generated by sources of mains AC, which have frequencies of about 50 to 60 Hz. Besides home or static sources, electric vehicles shall be also considered, such as trains, tramcars, subway trains, trolley-buses, etc., due to the considerable powers absorbed and the strengths of the fields generated thereby.

A third category might include noise fields with frequencies of the order of a fraction of the mains frequency, i.e. of about 10 to 20 Hz. Particularly, some railway electrification lines use, for instance, one-third of the mains frequency, that is a frequency of the order of 16 Hz.

Other noise fields consist of fast, i.e. high-frequency transients. In spatial volumes containing significant electrically conductive masses, e.g. shielding magnetic structures or Faraday cages, these fast transient induce noise currents, which modify the noise fields inside the imaging cavity, These fast magnetic field transients may be also combined with other noise types.

Currently, the methods of compensation for magnetic fields like the ones described hereinbefore use a single sensor and jointly compensate the fields with different frequencies. Joint processing extends from the detection of noise fields, through the generation of compensation fields, to the calculation of the noise fields generated inside the spatial volume, based on the results of measurements outside the spatial volume.

Document EP-0 445 960 discloses a method of reducing slice profile degradation due to gradient signal amplitude ripple. This method has the steps of: sensing the gradient signal ripple amplitude; normalizing the sensed ripple signal amplitude responsive to the gradient amplitude commanded; and modulating the RF signal amplitude with the adjusted-amplitude ripple signal, to cause the RF and gradient magnetic fields to have an effective vector pointing substantially in the same direction during the slice-selection interval, as would the effective field vector formed with a gradient field devoid of ripple. Document EP-0 445 960 discloses also an apparatus for reducing the slice profile degradation which modulates the RF signal with the ripple envelope obtained from the output of the gradient signal amplifier, by a signal controlled by the gradient amplifier input.

Document WO-92/18873 discloses an apparatus and method for stabilizing the background magnetic field during MRI. A pair of serially-connected coils L1 and L2 detect noise variations in an MRI background magnetic field. Although the coils L1 and L2 are closely coupled to the primary background magnetic field generator of the MRI system, they are disposed so as to be substantially decoupled from rapidly changing MRI gradient magnetic fields. The noise detecting loops drive a negative feedback loop including a low pass filter, amplifier and controlled current source driving a large correcting loop L3. The device attenuates background magnetic field noise during MRI data acquisition over a frequency band extending from a few millihertz to more than 100 Hz. It is preferably used with existing field stabilization software that otherwise compensates for fluctuations in an overlapping frequency band which starts at d.c. Thus, when used together, background magnetic field noise may be attenuated or compensated for in subsequent MRI data processing over a frequency band that extends from d.c. to more than 100 Hz.

The invention has the purpose of improving prior art methods to obtain a better and more accurate noise field compensation.

The invention achieves the above purposes by providing a method according to the preamble of claim 1 further comprising the combination of features of the characterizing part of claim 1.

This may be obtained by using, for at least some of the noise fields with frequencies in the range of the at least two, three or more frequency bands, the same correlation law to correlate the parameters of the outside noise field/s to the inside noise field/s, or the same correlation law to calculate the magnetic noise fields inside the spatial volume, based on the measurement/s of the noise fields outside the spatial volume and/or the same means for generating the corresponding compensation fields for at least some of the magnetic noise fields with frequencies in the range of the at least two, three or more different frequency bands.

Alternately, laws may be provided for correlating the noise fields detected outside the spatial volume and the corresponding noise fields inside the spatial volume, which are different for each of the at least two, three or more frequency bands provided for discriminating the different types of noise fields or which are different for at least some of the at least two, three or more discriminating frequency bands.

As an alternative to or in combination with the above, means may be also provided for generating magnetic compensation fields which are different for all or at least some of the at least two, three or more frequency bands that are used to discriminate the different noise field types.

Again, as an alternative to or in combination with the above, at least one common detection probe may be provided for detecting the noise field/s with frequencies in the range of all or at least some of the at least two, three or more frequency bands or at least one different probe may be provided for the noise fields with frequencies in the range of all of the at least two, three or more discriminating frequency bands.

Thanks to the above, a compensation field may be selectively generated for any type of noise field frequency, thereby optimizing the detection of the noise field, the correlation law to relate the noise field detected outside the spatial volume and the noise field inside it, and the means for generating the compensation fields.

Furthermore, a considerable advantage is also achieved in terms of construction costs. In fact, while the invention requires more expensive hardware, nevertheless, by separating the hardware into sections corresponding to the different frequency ranges, simple and inexpensive units may be used, such as variable gain amplifiers, which operate and are only meant to have an optimized performance in narrow frequency bands.

A closer analysis of the noise fields shows that the latter can have several different degrees of freedom, i.e. different variable parameters, whereby the distribution of the noise field inside the spatial volume may be determined by using systems of equations based on the laws of electromagnetism which allow to determine all the parameters. Typically, for instance, with reference to noise fields that may be associated to dipoles by an approximation to the linear field describing coefficients, these dipoles have fixed orientations, i.e. are parallel to the earth's magnetic field. All dipole strength and position parameters are free. In this case, if the field is measured by using two probes disposed in different locations, a system of two equations may be generated, which allows an accurate determination of the two above mentioned parameters.

In accordance with an additional advantageous characteristic, the method of the invention also includes the steps of defining the degrees of freedom, i.e. the variable parameters of the individual noise fields, and of measuring the noise fields at a number of different locations, outside the spatial volume, which number corresponds to the number of degrees of freedom or variable parameters, a system of equations being generated on the basis of these different measurements, which equations have a number of functions for correlation with the field inside the spatial volume, which number is equal to that of the measurements, and whose solution allows to determine all the variable parameters of the magnetic noise fields.

Yet another characteristic of the inventive method consists in also providing, alternatively to or in combination with the above, an empirical method for determining the functions for correlation between the noise fields outside the spatial volume and the noise fields inside it, hence a more accurate determination of the magnetic compensation fields.

This additional characteristic includes the following steps:
generating a static magnetic field in the spatial volume, which magnetic field has such a strength and homogeneity as to be suitable for Magnetic Resonance imaging;
introducing a phantom in said static magnetic field, whose response to nuclear spin echo excitation is known;
exciting nuclear spin echoes in said phantom;
receiving nuclear spin echoes from said phantom when fields are provided for compensating for the noise fields in the spatial volume;
comparing actually received data with well-known data;
adjusting the parameters of the functions that are used to calculate or correlate noise fields outside the spatial volume and noise fields inside the spatial volume, on the basis of the differences obtained by the above comparison, and in such a manner as to neutralize or minimize said differences.

This additional characteristic allows to further improve the compensation accuracy and to empirically adjust the functions for calculation or correlation between outside noise fields and inside noise fields.

In first approximation, the frequency response of nuclear spin echoes is analyzed, and the discrepancy between the detected frequency and the theoretical well-known phantom frequency response is used to adjust the parameters of the correlation or calculation functions, particularly, the gain of compensation field generators.

According to another improvement, the comparison results may be displayed in graphic form on a monitor, graphic means being provided to adjust the displayed representation, which means automatically generate controls for correcting the parameters of the calculation or correlation functions, corresponding to graphic changes.

An additional characteristic of the inventive method consists in the provision of the following steps:
Performing multiple noise field detections in time;
Determining the maximum amplitude range of the noise fields, by determining, in a given time, the maximum and minimum values of the noise field curve;
Determining the compensation field from the measured noise field, by subtracting therefrom the offset or average compensation field value, which is calculated from the detected noise field;
Generating the compensation field so determined.

The above is a sort of automatic offset, which allows to reduce the power requirements of compensation field generation. In fact, it should be noted that, in most applications, the simple presence of an outside static magnetic field does not cause noise or operational problems, and only time dependent components cause considerable operational failures. Hence, compensation field generation shall only account for the time dependent component of the noise field. In graphic form, the above steps substantially consist in displacing a wave-like curve, which describes the field fluctuations caused by the noise field, so that these oscillations are deemed to occur close to a line having a zero value.

Regarding the compensation for noise fields consisting of fast transients, which are altered by currents induced in electrically conductive structures, contained in the volume of interest, said compensation is performed by providing an exponential distribution for these high-frequency fields, whereby compensation field generating currents are created which have a substantially inverse exponential curve. These currents are superimposed on the currents for generating compensation fields for low-frequency noise field types, and provide a sort of "overshoot" for the currents for generating noise field compensating fields.

The invention also relates to a device for compensating for magnetic noise fields in a spatial volume, which device comprises the combination of features of claim 23.

In accordance with an improvement, a set of filters may be provided, whose passband is such as to divide a frequency range into at least two different frequency bands or into three or more frequency bands.

Separate and different means for calculating the magnetic noise fields inside the relevant volume, operating with different functions, may be provided for each frequency band of the magnetic noise fields or for subsets of frequency bands.

Alternatively to or in combination with the above, separate and different means for generating compensation fields may be provided for each frequency band or for subsets of frequency bands.

The device may have a single probe outside the spatial volume, which is connected to a single computer unit for determining the noise field inside the spatial volume and to a single unit for generating the compensation field.

Particularly, the device may have a single probe outside the spatial volume, which is connected to a single computer unit for determining the noise field inside the spatial volume and to a plurality of generator units for generating compensation fields for the different frequencies according to the at least two, three or more predetermined noise field frequency bands, the probe being used in succession for detecting noise fields with frequencies in the range of the at least two, three or more predetermined frequency bands, there being provided variable passband filtering means, or different filters with different passbands, for alternate connection to the probe, and the computer unit for determining the noise fields inside the spatial volume being programmable and provided with a storage unit containing the different functions for calculation of noise fields inside the spatial volume, on the basis of the noise fields detected by the probe outside the spatial volume, and for correlation between the noise fields outside the spatial volume and the corresponding fields inside the spatial volume, whereas the algorithms corresponding to said inside field calculation and correlation functions, depending on the operating passband filter, are loaded and executed in the working storage, and the data of the so determined inside noise field is transmitted to a compensation field generator, dedicated to the corresponding frequency band.

In accordance with another improvement, the device may have multiple permanent probes, each dedicated to the detection of noise fields outside the spatial volume, with frequencies in the range of one of the predetermined frequency bands or a subset of the predetermined frequency bands, a unit for calculation or correlation of inside noise fields for each predetermined frequency band or subset of predetermined frequency bands, as well as a compensation field generator unit for each frequency band or each subset of frequency bands.

The compensation field generating unit/s include an electronic unit which generates a current to operate one or more magnetic field generating coils, such as solenoids or the like, although a single compensation field generating coil may be provided, which is or may be connected to the different units for generating compensation field exciting currents for the noise fields with frequencies in the range of the at least two, three or more predetermined frequency bands.

A compensation field generating coil may be provided for each separate unit that generates the compensation field exciting currents, which is associated to one of the at least two, tree or more predetermined frequency bands or to a subset of said at least two, three or more frequency bands.

Another characteristic of the device consists in that the latter has at least two, three or more probes, positioned outside the spatial volume in different locations, and each designed to detect the noise field outside said spatial volume at the different probe locations, with frequencies in the range of at least one frequency band of the at least two, three or more predetermined bands, an algorithm being loaded in the computer and correlation unit, for generating and solving a field describing system of equations, each equation consisting of the calculation or correlation equation applied to the data detected by one of said at least two, three or more probes, which solution of the system of equations provides all the field describing variable parameters contained in said calculation and correlation functions.

According to yet another improvement, the device is provided in combination with internal probes which measure the field inside the spatial volume, there being provided means for comparing the noise field/s inside the spatial volume which are obtained by a calculation based on measured outside fields, and the fields inside the spatial volume which are measured by the internal probes, as well as means for manually adjusting the parameters of the calculation and correlation functions to minimize the differences between the calculated inside fields and the actually measured inside fields.

Advantageously, the probes situated inside the spatial volume are active probes, i.e. generate a predetermined test field, whose characteristics are well-known and predetermined in a no-noise condition, while the comparator receives the measurements of said inside test field and the nominal known values of said test field and there being provided means for manually adjusting the parameters of the calculation and correlation functions to minimize the differences between the known test field data and actual test field measurement data.

As a further improvement of the use of the test field and of the probes for measuring it, a device is provided for exciting and detecting Magnetic Resonance echoes in a predetermined phantom.

This device includes means for generating a static field inside a predetermined volume, a coil for transmitting nuclear spin exciting pulses, a coil for receiving echoes from said nuclear spins, and a phantom having well-known response characteristics related to said Magnetic Resonance echoes, means for determining the frequency of said Magnetic Resonance echoes and means for comparing said Magnetic resonance echo frequency with the well-known frequency, means for adjusting the parameters of the calculation or correlation function/s and/or of the compensation field generators, to minimize or neutralize the difference resulting from the comparator output.

Particularly, the frequency of Magnetic Resonance echoes is detected and compared with the well-known frequency, the parameters of the calculation and correlation functions and/or the compensation field generating currents being adjusted to neutralize or minimize this frequency difference.

The parameters of calculation or correlation functions and/or of compensation field exciting current generation may be adjusted automatically by means of feedback units, which adjust the parameters of calculation or correlation functions and/or the characteristics of the compensation field generating current on the basis of the difference signal resulting from the comparator.

A manual adjustment may be also made by using input means, through which controls may be input for adjusting the parameters of the calculation or correlation functions and/or the compensation field generating currents.

According to an advantageous embodiment, the device has means for displaying the parameters or the curve of the test field and/or the outside noise fields and/or both theoretical or known and actual or measured inside fields, in alternate, overlapped and/or tiled form, graphic interface means of graphic input means through which controls are input, which change the aspect of the magnetic fields and/or the parameters thereof and means for univocal association of a change to the parameters of the calculation and correlation functions and/or to the compensation field generating currents in response to the selected graphic changes.

It shall be noted that the means and units of the device may be units with a dedicated construction or computers, as well as small suitably programmed PCs, having interfaces for connection with the outside noise field and/or inside noise field measuring probes, and with the compensation field generating coils and/or with the test field generating and measuring devices, while the software for executing probe signal reading functions, calculation and correlation functions to determine inside noise fields, current generating functions to create compensation field generating currents, comparison functions, functions for automatic determination or manual setting of adjustments to the parameters of calculation and correlation functions and/or to compensation field exciting current generation functions, as well as the software for displaying and controlling the alphanumeric and graphic manual data input interfaces is loaded in said computer or PC.

Referring now to a particular application of the field compensation device, the latter is provided in combination with a Magnetic Resonance imaging apparatus, said apparatus being situated in a delimited space, which forms the spatial volume wherein the noise fields are to be compensated for, and the Magnetic Resonance apparatus being used as an internal probe for detecting the conditions of the magnetic field inside said space based on the changes made to a well-known static field.

The Magnetic Resonance imaging machine includes all the components of an active probe, i.e.: means for generating a static test field, coils for transmitting exciting pulses, coils for receiving nuclear spin echoes, an electronic unit for processing the received nuclear spin echo signals and electronic units that can be programmed in such a manner as to execute the comparison between the static field characteristics derived from nuclear spin echo receiving signals and the known characteristics of the static field, by simply providing a test phantom and a difference signal output interface with the noise field compensation device.

Here, since Magnetic Resonance imaging apparatuses are provided with display means, the graphic processing and display section of said apparatus may be used to display the curve of the test magnetic field as obtained by actual measurement, and that associated to known and predetermined characteristics, and to make appropriate adjustments aimed at minimizing or neutralizing the differences between the actual test field and the test field having those known and predetermined characteristics, i.e. the nominal test field, the data of said adjustments being transmitted through a special transformation interface, which transforms them into control signals, to be transmitted to the noise field compensation device. The invention also relates to a Magnetic Resonance imaging machine including a cavity for accommodating a body under examination or a part thereof, means for generating a static field which permeates said cavity, at least one exciting pulse transmitting coil, at least one nuclear spin echo receiving coil, at least one compensation coil and at least one gradient coil, and there being provided an electronic apparatus controlling unit to operate the transmitting coil, the compensation coil and the gradient coil/s and which receives nuclear spin echo signals from the receiving coil, processes them and displays the corresponding images.

According to this invention, the apparatus incorporates a noise field compensation device inside the cavity wherein the body under examination or a part thereof is accommodated.

The said apparatus showing the combination of features of claim 49.

The apparatus incorporates a noise field compensation device inside the cavity wherein the body under examination or a part thereof is accommodated, there being provided at least one probe for detecting the noise fields outside the cavity, means for determining said noise fields inside the cavity on the basis of external measurement/s by executing theoretically or empirically defined calculation or correlation functions, means for generating compensation fields for inside noise fields.

The above means may be separate units, different from the specific control and processing units of the Magnetic Resonance imaging apparatus, or some or all of them may be existing units of the Nuclear Magnetic imaging apparatus.

For instance, according to a first embodiment, the compensation field generator means are made of the compensation coil/s and/or by the gradient coil/s.

The use of gradient coils may be advantageous for compensating for noise fields which cause field non homogeneities inside the imaging cavity of the Magnetic Resonance imaging apparatus. It shall be noted that this is indeed possible thanks to the fact that the compensation device is closely integrated in the Magnetic Resonance imaging apparatus. This close integration, whereby almost all the components of the compensation device, except the probes, are existing units of the Magnetic Resonance imaging apparatus, allows to operate and control even the gradient coils, with no expensive construction requirement, by setting the gradient field in such a manner as to compensate for any noise field induced non homogeneity.

Also, when the apparatus has a programmable control and processing unit, all the means of the noise field compensation device are the electronic units of the Magnetic Resonance imaging apparatus, in combination with software for executing noise field and compensation field measurement and determination functions.

Particularly, the Magnetic Resonance imaging apparatus has an input for at least one probe, preferably for at least two, three or more probes for detecting fields outside the cavity of the apparatus itself, and units for interfacing these probes with the control and processing unit of the apparatus, while a program for executing the compensation procedure is loaded, which determines, by using preset calculation and correlation functions, the inside noise fields and the compensation and/or gradient coil exciting current, to be superimposed on the currents for generating normal compensation and gradient fields to obtain noise field compensation fields.

As disclosed above regarding the method and device, the Magnetic Resonance imaging apparatus may include an interface for connection with one or more probes, which interface has means for setting frequency thresholds, to determine at least two different frequency bands of noise fields or filters having a passband that may be or is set on different frequency bands for separate measurement of noise fields having different frequencies.

In this case, the apparatus may have individual hardware units or specific software programs loaded in the control and processing unit thereof, separate computer units for determining the inside noise fields, by using optimized calculation or correlation functions for each frequency band of the at least two available frequency bands.

Similarly, the apparatus may have individual hardware units or specific software programs loaded in the control and processing unit thereof, separate units for generating compensation fields for the in-cavity noise fields, for each frequency band of the at least two available frequency bands.

Still as described above for the noise field compensation device, the separate units for generating the compensation fields for the inside noise fields for each frequency band of the at least two frequency bands being used may consist of a single generator unit which generates currents for exciting a single compensation coil, or of multiple separate generator units for each frequency band in use, which operate compensation field generating coils, individually or in separate sets.

The above shows that the generator units in the Magnetic Resonance imaging apparatus, which generate currents for exciting substantially homogeneous compensation fields inside the imaging cavity of the apparatus, operate the static field compensation coils of the apparatus, whereas the generator units which generate currents for exciting compensation fields for non homogeneous noise fields in said imaging cavity modulate the currents for exciting one or more gradients provided to the gradient coils of the Magnetic Resonance imaging apparatus as soon as these magnetic gradients are operated.

According to another improvement, the Magnetic Resonance imaging apparatus also has means for measuring the actual magnetic field inside the cavity, which consist of the static field generators, the exciting pulse transmitting coils, the nuclear spin echo receiving coils, as well as the control and processing unit of the apparatus itself, there being provided a phantom to be accommodated in the cavity of the apparatus and a software program for measuring the actual field in the cavity, which program is loaded in and may be executed by the control and processing unit, and includes the steps of transmitting exciting pulses to the phantom in the cavity, receiving nuclear spin echoes from the phantom, determining the field curve inside the cavity from the received echoes, and comparing the received echo frequency and/or the actual inside field curve with the nominally or theoretically expected echo frequency and/or with the nominal or theoretically expected static field curve.

As described above with reference to the noise field compensation method and device, by using dedicated hardware processing units or appropriate software programs loaded in the control and processing unit of the Magnetic Resonance imaging apparatus, the comparison result may be automatically processed by the dedicated hardware units or by the processing unit of the apparatus, and transformed into signals for correcting the inside noise field calculation functions on the basis of the detections performed by the probe/s outside the cavity and/or into signals for correcting the compensation field/s exciting currents. Hence, the full integration of the noise field compensation device with the Magnetic Resonance imaging apparatus further allows compensation to be effected in a fully automatic manner, i.e. no intervention is required from the user.

Obviously, a semimanual or manual mode may be always set.

In this case, the comparison result may be displayed graphically, e.g. on a display, and manual input means may be provided to input correction parameters either alphanumerically and through graphic devices for adjusting the actual curve of the displayed field, which parameters are interpreted by the apparatus and transformed into appropriate control signals, there being provided dedicated hardware units or suitable software programs in the control and processing unit of the Magnetic Resonance imaging apparatus.

As is apparent from the above description relating to the Magnetic Resonance imaging apparatus, the noise field compensation device integrated therein may have all the characteristics and combinations or sub-combinations of characteristics as provided for the noise field compensation device which forms a self-standing and independent operating unit. It is apparent that this integration in the Magnetic Resonance imaging apparatus allows to reduce construction costs for the device, the individual operating units of the device being included in the Magnetic Resonance imaging apparatus and the different features required for noise field compensation being executable by suitable software for managing the control and processing operating units resident in the apparatus, according to the functional requirements of the noise field compensation method in use.

In fact, when the noise field compensation device is integrated in the Magnetic Resonance imaging apparatus, considerable savings on the total cost of the two devices are obtained, in addition to important functional advantages.

Further, according to another characteristic, full integration of the noise field detection and compensation device in the Magnetic Resonance imaging apparatus allows to use a particular Magnetic Resonance imaging method. In addition to the normal known steps of Magnetic Resonance imaging and image reconstruction from imaging data, this method includes the further following steps:
measuring noise fields before executing imaging steps;
calculating compensation fields and exciting currents before executing imaging steps;
generating compensation fields during the whole Magnetic Resonance imaging time.

Possibly, a compensation check step may be provided at the end of the Magnetic Resonance imaging sequence.

Such a check step may be executed alternatively to or in combination with other compensation field checking steps, even immediately before or immediately after compensation field generation, e.g. by using, as described above, the Magnetic Resonance imaging apparatus as a magnetic field sensor in the imaging cavity.

Particularly, the Nuclear Magnetic Resonance imaging method includes the following steps: setting parameters for correlation and/or calculation of noise fields inside the imaging cavity, based on the noise fields detected outside said cavity;

Measuring the actual magnetic field inside the cavity while the compensation fields are active, and correcting the correlation and/or calculation functions for the noise field inside the cavity and the compensation fields, based on the comparison between the nominal and/or theoretical value of the inside field and the actual field obtained by said measurement, immediately before the imaging steps;

Activating the compensation fields based on outside noise field measurements and on the inside field correlation and/or calculation functions as corrected during the preceding step;

Executing substantially simultaneous nuclear spin echo signal excitation and detection steps in compliance with Magnetic Resonance imaging modes;

Reconstructing images from these received signals;

Repeating, if needed, the noise field compensation and imaging steps.

In combination with the above steps, an additional measurement step may be provided to determine the actual in-cavity field, when the compensation fields are active and the inside noise field correlation or calculation functions have been corrected and/or the compensation field is generated by comparing the actual measured value and the nominal, theoretical value of this in-cavity field, even when the Magnetic Resonance imaging steps have been executed.

Particularly, when a succession of Magnetic Resonance imaging operations are executed, it is possible to interpose, between individual sequences of imaging steps leading to successive images, a step in which the actual magnetic field is measured inside the imaging cavity, and the correlation or calculation functions for the outside noise field and the inside noise field are corrected, and/or the compensation field for the inside noise field is generated.

The compensation for the noise generated by fast transients, by equating them with exponential curve fields and the determination of inverse compensation field generating currents, allows to use the units contained in the above device, by suitably programming these existing units or replicating them, if a dedicated or separated treatment is needed.

The invention provides further improvements which will form the subject of the appended claims.

The characteristics of the invention and the advantages derived therefrom will appear more clearly from the following description of a few non limiting embodiments, illustrated in the annexed drawings, in which:
Fig. 1 shows a simplified block diagram of a first embodiment of the apparatus according to the invention.
Fig. 2 shows a simplified block diagram of a device as shown in Fig. 1, which further comprises an active probe for measuring the noise field inside the spatial volume.
Fig. 3 shows a simplified block diagram of a variant embodiment of the device according to the previous Figures.
Fig. 4 shows a simplified block diagram of the device according to the previous Figures, having means for measuring the noise field inside the spatial volume and automatic or manual means for correcting the inside noise field calculation function and/or the currents for generating compensation fields for these inside noise fields.
Fig. 5 shows a block diagram of a Magnetic Resonance imaging apparatus, which integrates a noise field compensation device according to the invention.

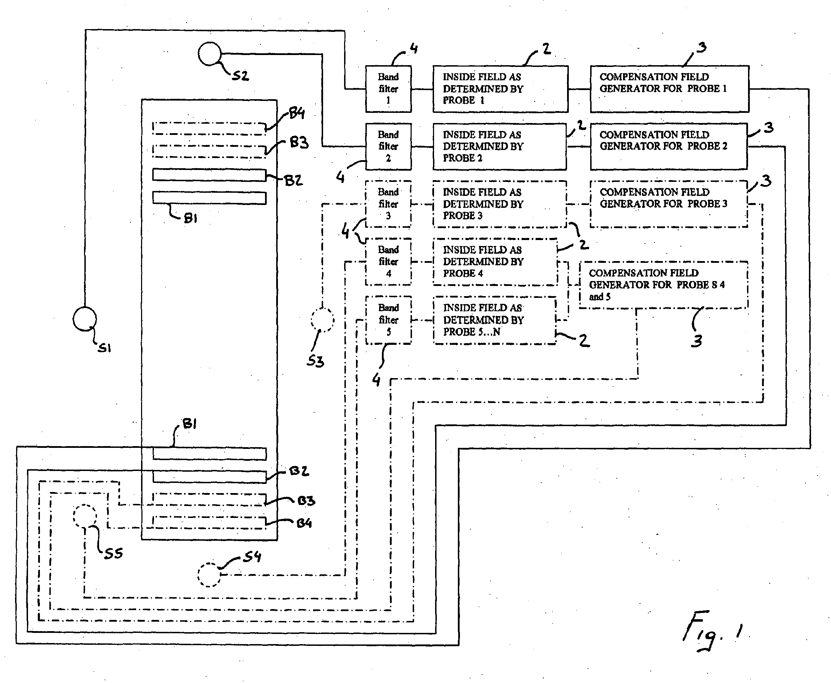

Referring to Figure 1, a device for compensating for magnetic noise fields in a spatial volume V has at least one probe S1 for measuring noise fields, which is disposed outside the spatial volume V.

The probe S1 may be of any type, such as a small Hall probe or a small coil, or the like. The probe S1 is connected to a processing and compensation field generator unit, which includes a unit for calculating or correlating the values of the noise field inside the spatial volume V based on the noise field values detected by the probe S1 outside the spatial volume V. This unit performs the calculation and/or correlation operations by using theoretical or empirical functions, i.e. deriving from the laws of electromagnetism and/or from experiments.

The calculation or correlation unit 2 may be a hardware unit which permanently incorporates mathematical functions in its circuits, by using widely known and used circuit components or units to execute the different mathematical operations on electric signals, or the unit advantageously consists of a programmable electronic unit, such as a microprocessor or the like, associated to a storage unit and provided in combination with different software programs for the execution of several functional steps.

Then, the signal output from the unit 2, which corresponds to a value of the noise field inside the spatial volume V is used to generate a compensation field. To this end, the unit 2 controls, by this signal, a compensation field generator 3, which substantially consists of a power supply or generator, which operates one or more coils B1 for generating the compensation field inside the spatial volume V, which coils are located in this volume or in such a manner as to generate a compensation field which permeates this volume.

Again, the compensation field generator 3 may be a hardware board having a permanent construction, or a programmable and highly flexible unit. It shall be noted that these units, whose functions are described above, are widely used and known in the field of electronics and that those skilled in the art need only know the expected functional operations to easily determine the required components and the most appropriate selections, in response to specific needs.

The above device has a so-called open-loop structure, wherein the feedback loop is closed for compensation field control by applying the law, i.e. the calculation function which determines the inside magnetic field from outside measurements. This structure is particularly advantageous when the spatial volume is the space wherein measuring devices whose operation is magnetic field dependent are accommodated, wherefor the presence of probes may affect operating conditions.

Here, the outside location of the probe provides the greatest freedom in positioning the probe and in changing at will the number of probes in use.

Moreover, by using an open-loop configuration, magnetic compensation fields may be continuously changed. This is advantageous, for instance, in Magnetic Resonance imaging apparatuses, wherein the compensation device may operate during the imaging step, and correct noise fields in real time, while the correction loop is not affected by the magnetic fields required for Magnetic Resonance imaging nor the latter is affected by the former.

According to a first concept of this invention, which is clearly shown in Figure 1, the device has frequency band definition means 4, which are used to detect and/or discriminate noise fields with different frequencies. In fact, as mentioned above, magnetic noise may be generated by several different types of sources and, depending on the latter, noise fields may have different frequencies. A first type of noise field is mainly determined by street traffic or the like, which generates noise fields with frequencies of the order of a few Hz. A second type includes magnetic fields generated by sources which use mains Alternating Current, such as railways or tramways, or the like. In this case, noise fields have frequencies of the order of mains frequency. Furthermore, electric sources may exist which use currents with frequencies corresponding to a rational fraction of the mains current, which generate noise fields having frequencies of about 10 to 20 Hz. A practical analysis of noise fields leads in first approximation to two, or possibly three noise field types which have markedly different frequencies, and may be discriminated from each other and processed separately in an optimized manner. Further regarding magnetic field propagation laws, the two or three different types may differ due to the considerable difference between the generation sources associated to the corresponding noise fields.

From the above, multiple separate filtering means may be provided, as shown in Figure 1, which denotes them with numeral 4, which means have each a different frequency passband, and may be successively connected to a single probe S1. Here, the probe S1 is connected to the different filters 4 by means of a switch which may be programmed or controlled by a suitably programmed processor. As an alternative to the above, a single programmable filtering circuit 4 may be provided, which is controlled by a microprocessor unit. A software program, loaded in the microprocessor would set the filtering circuit to the different frequency bands, in succession, for a predetermined time.

As a further alternative, which is shown in Figure 1 by dashed lines, each frequency band may be associated to a probe S1, S2, S3, S4, S5. In this example, five frequency bands are provided, each with its own filter 4, connected to a corresponding probe S1, S2, S3, S4, S5. The output of each filter 4 is connected to noise field calculation means. Once more, regarding these calculation means 2 for determining the noise field inside the spatial volume V, separate electronic units may be provided for each frequency band being considered, i.e. for each filter 4, as shown in Figure 1, or a single calculation unit 4 may be provided with different calculation programs being optimized, if needed, for the different frequency bands considered for noise fields, which unit determines the field inside the spatial volume by using the corresponding algorithm, in synchronism with the detection of the outside noise field within the corresponding frequency band.

Then, the data of the noise field inside the spatial volume V is transmitted to the means 3 which generate the compensation field exciting current.

Like the above units, the compensation field generator means 3 may themselves be separate for each frequency band in use, as shown in Figure 1, particularly with reference to the frequency bands that are associated to the filters connected with the probes S1, S2, S3. As an alternative thereto, the signal output from the inside noise field calculation means 2 may be transmitted to control a common compensation field exciting current generator unit, as shown in Figure 1 for the frequency bands detected by the probes S4 and S5. In this case, the signal outputs from the calculation means 3 associated to the frequency bands 4 and 5 are combined to generate one compensation field exciting current which includes the noise field frequencies in the range of those two bands. This may be obviously obtained for all frequency bands being considered.

The currents which generate the different compensation fields, output from separate generator means 3 may be supplied to a single compensation field generator coil; alternatively, each current may be used to feed individual coils for generating different compensation fields, which coils B1, B2, B3, B4 have an optimized construction for the corresponding frequency of the compensation fields that are to be generated thereby, as shown in Fig. 1 with reference to the outputs of the four excitation current generators 3 in use.

Figure 1 also shows that different subsets of compensation field calculating and generating channels may be combined, and that the currents which generate the compensation fields for these channel subsets (see the channels of frequency bands 4 and 5) are supplied to a common magnetic field generator coil, as shown by the coil B4.

As an alternative to what is provided for the channels associated to the frequency bands 4 and 5, a combination may be also provided between the currents output from separate means for generating compensation field exciting currents to operate a single common magnetic field excitation coil, in lieu of a combination of the signals output from the calculation means to determine the noise field inside the spatial volume V as shown in Fig. 1 and as described above.

Thanks to the use of programmable means, e.g. programmable filters, programmable calculating units and/or programmable exciting current generator units, the device provides a higher versatility, as compared with the configuration of special hardware units, each dedicated to a frequency band. This allows to adjust operational options, e.g. channel combinations, number of channels, etc. in as relatively inexpensive manner.

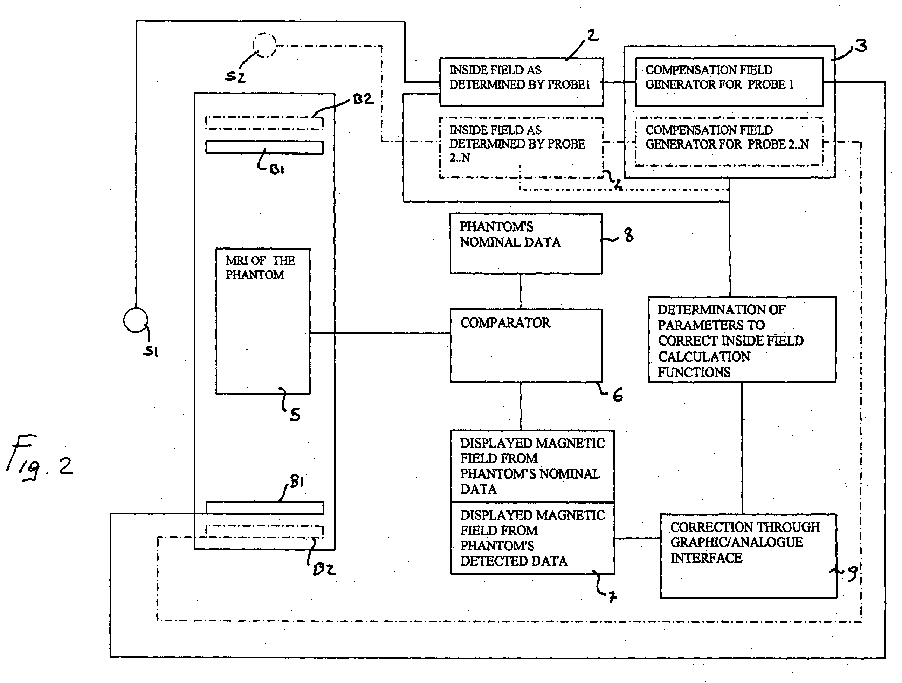

Fig. 2 shows another improvement of a device as shown in Fig. 1. In this embodiment, a small number of probes is shown, the probe S2 being defined by a dashed line, which symbolically indicates the possibility of providing a greater number of probes and/or channels associated to different noise field detection frequency bands.

In Figure 2, a probe or a device 5 for detecting the inside magnetic field is provided in the spatial volume V. The detecting probe or device 5 is connected at its output to a comparator 6, which is in turn connected with display means 7. Data input means 8 are further provided, which may be alphanumeric keyboard means and/or graphic means for graphically adjusting the displayed data.

According to a first operating mode, the detecting probe or device 5 inside the spatial volume V measure the actual noise field, and the latter is compared with the data of this field, resulting from the calculation, based on measurements of the outside magnetic field provided by the probe/s S1 and/or S2.

The comparator compares the two field curves and displays them on screen, in overlapped and/or tiled and/or alternate positions, or displays the comparator output. In this case, the display means and the comparator allow to highlight the differences between the calculated inside noise field, and the actual field, and to automatically adjust the parameters of the calculation function/s, depending on the provision of one or more channels for the different frequency bands, so as to minimize or neutralize these differences and as to ensure that the compensation field exciting currents are generated on the basis of more accurate data on the noise field/s inside the spatial volume V.

The display provides a visual representation of the automatic correction progress and/or allows manual interventions on the adjustment of the calculation function parameters by entering alphanumeric data through input means and/or by simply changing the graphic profile of the displayed field curve through graphic input means.

A unit for correlating graphic controls with the corresponding adjustments to calculation function parameters, generates the controls to be transmitted to current generator/s for correcting the currents generated based on or directly by calculation means 2, to directly correct the parameters of the calculation functions executed thereby.

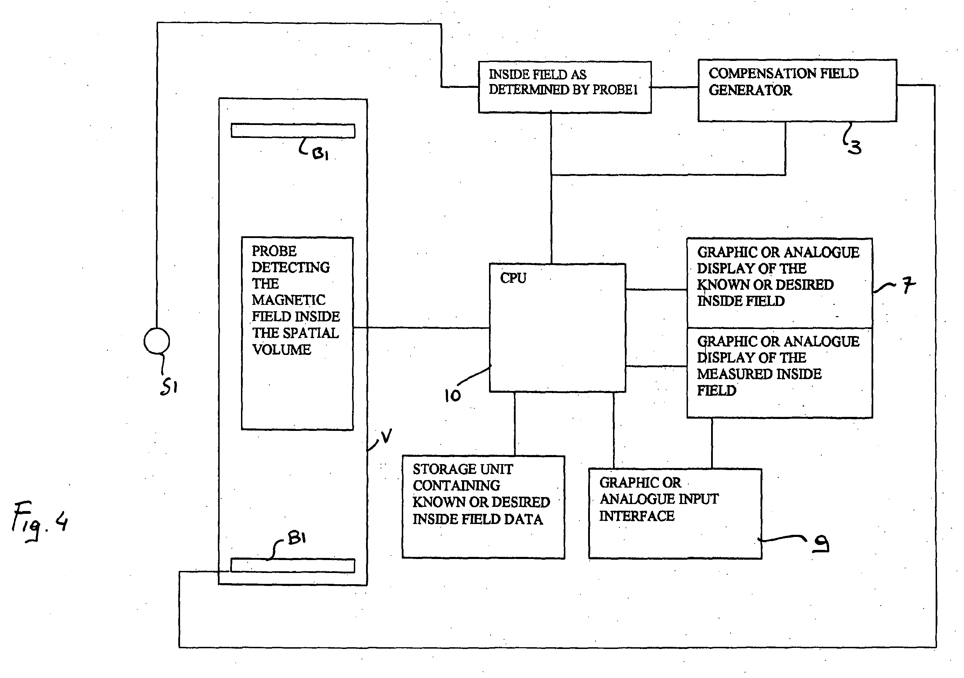

Fig. 4 shows a variant embodiment of the embodiment of Figure 2, wherein these functions are performed by a processing unit, which consists of a microprocessor or a computer, whose central processing unit 10 controls the computing means 2, the exciting current generator means 3, the display means 7, the comparator 6, which are all programmable and constitute peripheral units of the central processing unit.

Once more, the architecture of the device as shown in Fig. 4 allows a higher expansibility and flexibility relative to the number of probes and channels, and/or to the methods for executing the steps of noise field detection and calculation, of actual condition detection and comparison and/or execution of the above control procedures.

A variant embodiment, which is expressly shown in the Figure, replaces the detection probe inside the spatial volume V with a device for detecting compensation conditions, which operates on the basis of the changes to an active well-known static field, which is disposed inside the spatial volume V.

Here, there is no direct comparison between the inside noise fields determined from the measurements of the corresponding noise fields outside the spatial volume V, but the comparison is performed between the characteristics of the well-known static field as actually measured inside the spatial volume V and theoretically known characteristics.

Any type of device operating with the help of magnetic fields may be used for this purpose. Particularly, a suitable device for this purpose is a nuclear spin resonance echo detection device.

In this case, the device includes a so-called phantom, i.e. a test member having a known response to Magnetic Resonance stress. Inside the spatial volume V, the device 5 is used to excite and receive nuclear spin echoes from the phantom and to compare the data of said echoes with theoretical known data, which is stored in a suitable storage unit, as shown with numeral 8 in Figures 2 and 4.

From a first analysis, a simple comparison may be performed between the frequency of these detected nuclear spin echoes and the theoretically expected frequency thereof.

The curves of the actual static field may be determined from the received echo signals and compared with the theoretical field. As described above, here again, the corrections to calculation function parameters in calculation means 2 and/or to the currents for generating the compensation field/s may be determined by using either an automatic mode or a manual mode, by inputting alphanumeric data and/or graphic interventions, always with the purpose of minimizing or neutralizing the differences detected by the comparator.

The active static field device 5 may advantageously consist of a Magnetic Resonance imaging apparatus, which has the necessary means to excite, receive and process the nuclear spin echoes from a phantom and typically, in addition to the processing electronics, means for generating a static field, at least one coil for transmitting exciting pulses and at least a coil for receiving nuclear spin echoes. The combined use of a Magnetic Resonance imaging apparatus and a noise field compensation device may be particularly suitable to compensate for noise fields in the rooms wherein these apparatuses are located. As a rule, the apparatuses are inserted in Faraday cages which are housed in special rooms, which cages form the spatial volume V which typically contains a Magnetic Resonance imaging apparatus. Here, the probe/s S1, S2, S3, S4, S5 are located outside the Faraday cage.

This application is also advantageous for the fact that Magnetic Resonance imaging apparatuses generally have a programmable control and processing unit, which can accomplish some of the functions of the noise field compensation device, such as the functions of the calculation means 2, passband filters 4, compensation field exciting current generator means 3, comparator means 6 as well as displays 7, storage units 8, and alphanumeric and/or graphic input means 9. Hence, the above mentioned combined use of Magnetic Resonance imaging apparatuses and noise field compensation devices allows to drastically reduce fabrication costs for the device, which are limited to the probe/s S1, S2, S3, S4, S5 and to the compensation field generator coil/s.

According to another characteristic of the invention, which may be provided separately or in combination with the above characteristics, the device may have a plurality of probes S1, S2, S3 to Sn, associated to calculation means 3 and to compensation field exciting current generators, which probes are used to detect the same noise field (with reference to a possible discrimination into several frequency bands as described above) in several locations outside the spatial volume V, a system of equations being thereby generated, which allows to calculate all variable parameters some of them, i.e. the variable parameters that are particularly relevant, with reference to the desired approximation, for the law that describes the measured noise field. This provides more accurate calculation functions to determine the propagation of said noise field inside the spatial volume V, whereby more accurate compensation fields may be generated.

It shall be noted that the above structure provides various automation levels, which may range from automatic automation of the steps to correct the functions for correlation or calculation of noise fields inside the spatial volume V or compensation fields from the detection of these noise fields outside the volume, until full execution of the individual steps, based on individual manual controls or even individual manual operations. A hardware structure may be also provided which allows to set the automation level at will to always allow a manual intervention to partly or wholly complete or replace the automatic procedure.

The number of probes S1, S2, S3 to Sn in use depends from the number of the variable parameters to be determined, hence the number of equations required to solve the system of equations.

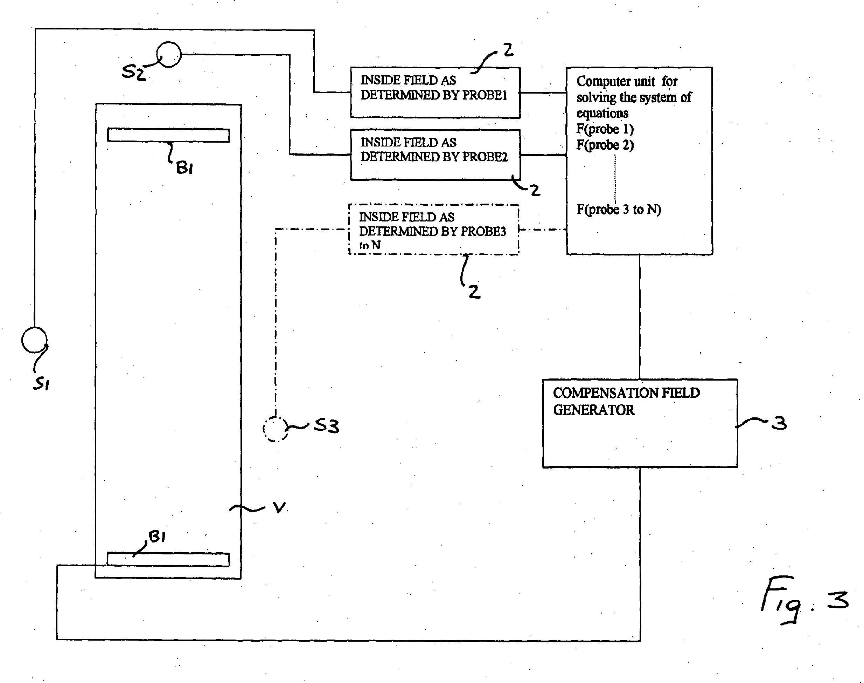

The above is schematically shown in Fig. 3. At least two probes S1, S2, and possibly multiple probes S3 are provided outside a spatial volume V. The measuring signals thereof are transmitted to the calculation means which generate a system of two or three equations, which system is solved by a calculation unit. The calculation unit provides, at its output, the calculation function to determine the field inside the spatial volume V, hence to control the compensation field exciting current generators 3, the currents being fully defined with reference to the selected number of variable parameters.

An easily understandable example consists in the treatment of noise fields caused by dipoles, e.g. the noise fields generated by vehicles, or the like. Here, the dipole will have a definite orientation, i.e. parallel to the field lines of the earth's magnetic field, however the variable parameters are the strength and position of the dipole. By detecting the same magnetic noise field twice, at two different locations and with two probes, two equations may be obtained to describe the magnetic field, and to determine the two strength and position variables.

Hence, the number of probes is defined by the number of degrees of freedom of the noise field.

While Fig. 3 shows the steps of this method in the form of functional electronic units, the device for implementing the above method advantageously has programmable and CPU controllable operating units. In this case, the method need not be executed by a device different from the above, but only requires an appropriate control program to be loaded in the CPU storage.

Obviously, the above functions may be also integrated with expressly dedicated hardware, if desired. According to another improvement which may be provided both separately and in combination with the above characteristics, the device may have means for detecting the static components of the noise field/s.

In this case, the noise field is analyzed relative to the amplitude oscillation band, e.g. by peak detectors or by sampling and measuring the individual maximum and minimum amplitudes for a predetermined time. Then, the inside noise field, and the associated compensation field are determined. The current for exciting this compensation field is determined by subtracting from the actual compensation field the possible offset, or average value of the actual compensation field, so that substantially only the variable component of the noise fields is compensated for, since the offset component does not particularly introduce noise effects or image deformation in Magnetic Resonance imaging. In short, the above operation displaces the compensation field in such a manner that a graphic representation of the compensation field curve in time shows it as being substantially centered around a horizontal straight line, representing time, which passes through the zero field value. This allows to limit compensation to time-dependent noise field components, hence to reduce power consumption and construction costs for the device. This mode is especially advantageous in technical and examination applications of Magnetic Resonance apparatuses, wherein the quality of the final image is not affected by the static contribution of noise fields, whereas the oscillating, i.e. time-dependent components, cause blurring or distortion effects and/or artifact generation.

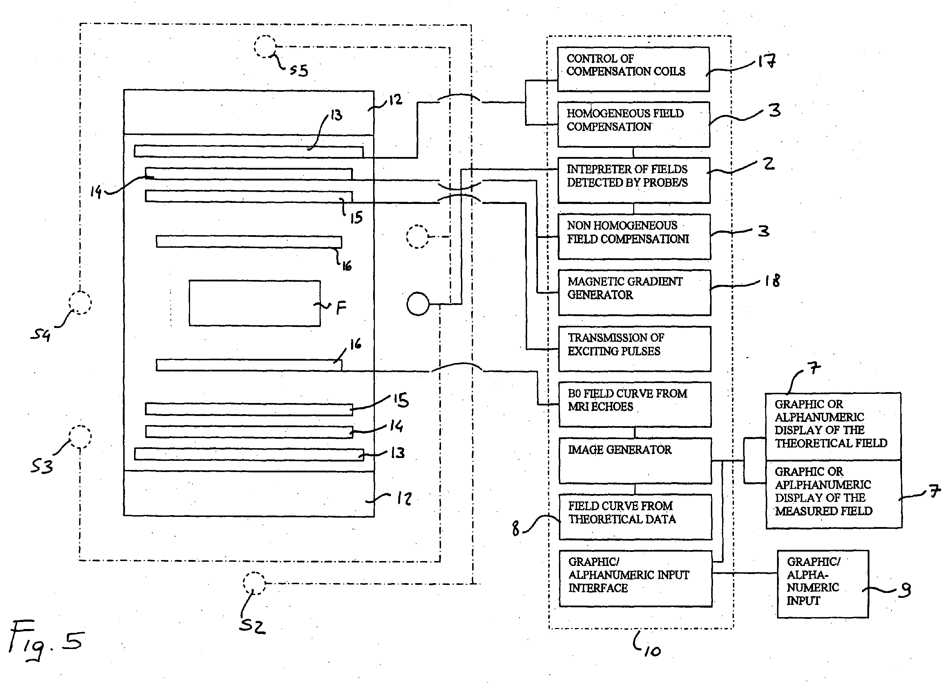

Finally, Fig. 5 shows a Magnetic Resonance imaging apparatus which integrates a device according to the invention, as described above.

Figure 5 only shows an embodiment thereof, and the noise field compensation device that is integrated in the Magnetic Resonance imaging apparatus may have one or more of the above characteristics, with reference to combinations or sub-combinations thereof. Even regarding construction, the device integrated in the Magnetic Resonance imaging apparatus may have all the construction variants or alternatives as indicated above.

In this case, the spatial volume wherein the noise fields are to be compensated for coincides with the cavity of the Magnetic Resonance imaging apparatus which is to accommodate the patient body or a part thereof and is also indicated as V.

Fig. 5 describes a preferred embodiment which includes at least one probe S1 and allows to use multiple probes as shown by the probes S2, S3, S4, S5, which are shown by dashed and dotted lines.

A dashed line and the numeral 11 denote the typical control and processing electronics of a Magnetic Resonance imaging apparatus, whereas the blocks included therein are additional functional units, or have functions accomplished by appropriately programmed or controlled units of the Magnetic Resonance imaging apparatus.

Referring to the noise fields that are relevant for Magnetic Resonance imaging apparatuses, two imaging and/or processing channels are provided, differing for the frequency bands that include the frequencies of the noise fields. Particularly, one of these bands includes values from less than one Hz to a few Hz, e.g. ½ to 9 Hz, particularly ½ to 3 Hz, and the other band has values from 10 to 60 Hz. The first band will be named low frequency band and the second high frequency band.

The Magnetic Resonance imaging apparatus includes means for generating a static magnetic field, which are denoted with numeral 12, e.g. two opposite poles of a magnetic structure, enclosing a cavity for accommodating the body under examination or a part thereof, which cavity includes, at the periphery of the area in which the body under examination or a part thereof is accommodated, at least one compensation coil 13, at least one exciting pulse transmission coil 14, at least one magnetic gradient generating coil 15 and at least one receiving coil 16. The Magnetic Resonance imaging apparatus obviously has, in its control and processing unit, all units to control and process the above coils for the ordinary operation of the apparatus.

The probe S1 and/or other possible probes S2, S3, S4, S5, S6 are connected to the input of means for calculating the noise field inside the cavity V of the Magnetic Resonance imaging apparatus from theoretical or empiric calculation functions, as described above regarding the simple noise field compensation device. Here, Fig. 5 shows in a single box the different calculation units of the embodiment of Fig. 1 and the corresponding filters 4. Similarly, these calculation units and filters may be associated to all variant embodiments as described above with reference to the compensation device only.

Particularly, advantages result from providing the calculation units 2 and/or the filters 4 in the form of software units, consisting of programs for controlling preexisting units of the Magnetic Resonance imaging apparatus, and particularly of the central processing and control unit, or possibly of the latter in combination with peripherals dedicated to perform filtering and/or calculation operations.

The signals of the noise field inside the cavity V are transmitted for each of the two low frequency and high frequency bands to means 3 for generating a compensation field exciting current. The currents that excite compensation fields for low-frequency and high-frequency noise fields are transmitted together with the currents 17 that operate the compensation coils 13, which are normally generated by the apparatus and are means to compensate for thermal drifts or static field variations that are due to other causes.

The compensation coils 13, already resident in the Magnetic Resonance imaging apparatus, are adapted to compensate for substantially uniform and homogeneous static field fluctuations, induced by outside magnetic fields, in the imaging cavity V. Nevertheless, some fluctuations may show some spatial variability within the cavity, i.e. spatial non homogeneities.

In this case, by suitably controlling gradient coils 18, compensation fields may be also generated for these field fluctuations, induced by noise fields, which have non-uniformities and non homogeneities in space.

As described above, the Magnetic Resonance imaging apparatus already has means to operate as a device which generates an active test field to check the effectiveness and accuracy of noise field compensation, based on the comparison between the theoretical or normal characteristics of the static field, and the characteristics that may be actually obtained from the excitation and reception of nuclear spin echo signals.

To this end, a phantom F is used, which has a well-known response to excitation. The methods for adjusting the compensation field generation parameters, either in automatic or manual alphanumeric input mode and/or by graphically adjusting the actual curve of the actually measured static field, resulting from the excitation and reception of nuclear spin echo signals from the phantom are the same as described above, and the necessary control and processing units are denoted with the same numerals as in the previous Figures. Here, the storage unit of the control and processing unit of the Magnetic Resonance imaging apparatus contains the control and processing programs required for operating the existing operational units to implement these methods.

The apparatus may also execute the same method steps as described with reference to Figure 3 to determine all the variables of the noise field describing functions by collecting different measures in different locations of the noise fields outside the spatial volume V (i.e. the cavity wherein the body under examination or a part thereof is accommodated) and of the functions for generating and solving a system of equations which describe this/these field/s, the number of these equations, i.e. of these measurements corresponding to the number of these variables.

Even this function may be accomplished by the Magnetic Resonance imaging apparatus, by simply loading therein suitable software programs for controlling operational units, typically resident therein.

Obviously, in view of the integration of the Magnetic Resonance imaging apparatus with the noise field compensation device, a particular preference is awarded to the apparatuses in which the structure of the control and processing unit is much the same as a computer, i.e. a PC or the like, in which the different functions simply consist of corresponding control and processing programs, and in which only a few specific units, such as power amplifiers, filters or interfaces for sensors, probes or the like, are specifically constructed and connected to this control and processing computer.

Still with reference to the above noise field compensation device, described as separate from the Magnetic Resonance imaging apparatus, the integrated configuration further provides a mode in which compensation fields may be limited to the amplitude oscillating band only, which allows to avoid the compensation for the static part of these fields. In this case, the static part is only an offset which does not change with time, and hence does not contribute in generating operational problems in the apparatus or imaging artifacts.

## Claims

1. A method for compensating for magnetic noise fields in spatial volumes, the said spatial volume being the imaging cavity of an MRI apparatus for accommodating the patient body or a part thereof on a room wherein the said apparatus is housed, comprising the following steps:
Determining the strength of a magnetic field outside said spatial volume;
Defining, on a theoretical basis, i.e. according to the laws of electromagnetism, or on an empirical basis, the correlation between the noise field outside the spatial volume and the corresponding noise field inside said spatial volume, or calculating the noise field inside said spatial volume, from the measurement/s of the magnetic field outside said spatial volume;
from the magnetic field inside said spatial volume, as determined theoretically or empirically, generating a magnetic compensation field, particularly for neutralizing the noise field in said spatial volume;
**characterized in that**
the method further provides separate detection of noise fields with frequencies in the range of at least two different frequency bands, or in three or more different frequency bands, and the determination and/or generation of the corresponding compensation field for all, or at least some of the noise fields with frequencies in the range of said at least two, three or more predetermined frequency bands, wherein said compensation field is different for at least some of the noise fields of said at least two frequency bands.

2. A method as claimed in claim 1, **characterised in that**, at least some of the noise fields with frequencies in the range of the at least two, three or more frequency bands, use the same correlation law to correlate the parameters of the outside noise field/s to the inside noise field/s, or the same correlation law to calculate the noise magnetic fields inside the spatial volume, based on the measurement/s of the noise fields outside the spatial volume and/or the same means for generating the corresponding compensation fields for at least some of the noise magnetic fields with frequencies in the range of the at least two, three or more different frequency bands.

3. A method as claimed in claim 1, or 2, **characterized in that** correlation laws are provided to correlate the magnetic noise field/s detected outside the spatial volume and the corresponding magnetic noise field/s inside the spatial volume, and that calculation laws are provided to calculate the latter fields, on the basis of the measurement of the noise fields outside the spatial volume, which laws are different for at least some or all of the magnetic noise fields with frequencies in the range of the at least two, three or more different frequency bands.

4. A method as claimed in one or more of the preceding claims, **characterized in that,** as an alternative thereto or in combination therewith, means may be also provided for generating magnetic compensation fields which are different for all or at least some of the at least two, three or more frequency bands that are used to discriminate the different noise field types.

5. A method as claimed in one or more of the preceding claims, **characterized in that,** as an alternative thereto or in combination therewith, at least one common detection probe may be provided for detecting the noise field/s with frequencies in the range of all or at least some of the at least two, three or more frequency bands or at least one different probe may be provided for the noise fields with frequencies in the range of all of the at least two, three or more discriminating frequency bands.

6. A method as claimed in one or more of the preceding claims, **characterized in that** it provides selective generation of compensation field/s for any noise field frequency, by optimizing noise field detection, the correlation law to correlate the noise field/s detected outside the spatial volume and the noise field/s inside it, or the calculation laws to calculate the latter from the measurements of the outside noise fields, and compensation field generation.

7. A method as claimed in one or more of the preceding claims, **characterized in that** it includes the steps of defining the degrees of freedom, i.e. the variable parameters of the individual noise fields, and of measuring the noise fields at a number of different locations, outside the spatial volume, which number corresponds to the number of degrees of freedom or variable parameters, a system of equations being generate on the basis of these different measurements, which equations have a number of functions for correlation with the field inside the spatial volume, or for calculation of said inside field or for description of the noise field curve, which number is equal to that of the measurements, and whose solution allows to determine all the variable parameters of the magnetic noise field and of the functions for describing it and/or for correlating the noise field inside the spatial volume and/or of the functions for calculating said noise field inside the spatial volume.

8. A method as claimed in claim 7, **characterized in that** the two, three or more measurements made at different locations outside the spatial volume are repeated for all or at least some of the magnetic noise fields having frequencies in the range of said at least two, three, or more predetermined frequency bands.

9. A method as claimed in one or more of the preceding claims, **characterized in that,** alternatively thereto, or in combination therewith, it includes the steps of determining the functions for correlation between the noise field/s outside the spatial volume and the noise field/s inside it, or the functions for calculation of inside noise field/s based on the measurements of the outside noise field/s and/or of determining the noise field describing functions and/or of determining compensation fields by control measurements of magnetic fields inside the spatial volume.

10. A method as claimed in claim 9, **characterized in that** it includes the steps of measuring the noise field/s inside the spatial volume, comparing the measured inside noise field/s with that/those determined on the basis of the measurements of noise fields outside the spatial volume, adjusting the variable parameter/s of said functions for calculating or describing the magnetic fields inside the spatial volume and/or the compensation fields, with the purpose of minimizing or neutralizing the differences as determined during the comparison.

11. A method as claimed in claim 9, **characterized in that** it includes the generation of a known static test field inside the spatial volume, and the detection of the actual characteristics of said test field, while said characteristics are compared with the well-known characteristics of said static test field, the variable parameters of said inside field and/or compensation field calculating or describing functions being adjusted to minimize or neutralize the differences resulting from the comparison between measured characteristics and well-known characteristics of the static test field.

12. A method as claimed in claim 11, **characterized in that** it includes the following steps:
generating a static magnetic field in the spatial volume, which magnetic field has such a strength and homogeneity as to be suitable for Magnetic Resonance imaging;
introducing a phantom in said static magnetic field, whose response to nuclear spin echo excitation is known;
exciting nuclear spin echoes in said phantom, by transmitting exciting pulses thereto;
receiving nuclear spin echoes from said phantom when fields are provided for compensating for the noise fields in the spatial volume;
comparing received data with well-known data or the characteristics of the static test field as determined from received signals with known characteristics;
adjusting the parameters of the functions that are used to calculate or correlate noise field/s outside the spatial volume and noise field/s inside the spatial volume, or the parameters of noise field or compensation field describing functions, on the basis of the differences resulting from the above comparison, and in such a manner as to neutralize or minimize said differences.

13. A method as claimed in one or more of claims 9 to 12, **characterized in that** the adjustment of the parameters of inside noise field and/or compensation field describing or calculating functions is determined manually, by alphanumeric data input and/or by controls designed to graphically change the comparison results.

14. A method as claimed in one or more of claims 9 to 12, **characterized in that** the adjustment of the parameters of inside noise field and/or compensation field describing or calculating functions is determined automatically.

15. A method as claimed in claim 12, **characterized in that**, a phantom is introduced into the static magnetic field of an MRI apparatus and the frequency response of nuclear spin echoes excited in said phantom is analyzed, and the discrepancy between the detected frequency and the theoretical well-known phantom frequency response is used to adjust the parameters of inside noise field correlation or calculation functions, and/or noise field and/or compensation field describing functions, particularly, the gain of compensation field generators.

16. A method as claimed in one or more of claims 9 to 15, **characterized in that** the comparison results are displayed in graphic form on a monitor, graphic means-being provided to change the displayed representation, which means automatically generate controls for correcting the parameters of inside noise field calculation or correlation functions, and/or noise field and/or compensation field describing functions, corresponding to graphic changes

17. A method as claimed in one or more of the preceding claims 9 to 16, **characterized in that** the steps of determining the functions for correlation between the noise field/s outside the spatial volume and the noise field/s inside it, or the functions for calculation of inside noise field/s based on the measurements of the outside noise field/s and/or of determining the noise field describing functions and/or of determining compensation fields by control measurements of magnetic fields inside the spatial volume are executed separately for each or at least some of the predetermined at least two, three or more predetermined frequency bands being used to discriminate noise magnetic fields.

18. A method as claimed in one or more of the preceding claims, **characterized in that** it includes the following steps:
Performing multiple noise field detections in time;
Determining, in a given time, the maximum and minimum values of the noise field curve;
Determining the compensation field from the noise field as measured according to the above, by subtracting therefrom the offset or average detected-noise field value;
Generating the compensation field for said noise field, wherefrom the offset or average detected noise field value is subtracted.

19. A method for compensating for noise fields in spatial volumes such as rooms containing Magnetic Resonance imaging apparatuses, as claimed in one or more of the preceding claims, **characterized in that** it includes the detection of noise field/s outside the room containing the Magnetic Resonance imaging apparatus, and the use of the control and processing units of the Magnetic Resonance imaging apparatus to execute the procedures of reading measure/s, and/or calculating inside noise field/s and/or defining the at least two or more predetermined frequency bands and/or generating compensation field exciting currents, there being provided one or more coils for generating compensation field/s inside the room wherein the Magnetic Resonance imaging apparatus is located and programs for controlling control and processing units of the Magnetic Resonance imaging apparatus to execute the steps of the noise field compensation method as claimed in one or more of the preceding claims 1 to 18.

20. A method as claimed in one or more of the preceding claims, **characterized in that** the spatial volume wherein noise fields are compensated for, is the cavity which houses the body under examination, or a part thereof, of the Magnetic Resonance imaging apparatus.

21. A method as claimed in claim 19 or 20, **characterized in that** the Magnetic Resonance imaging apparatus is also a device for measuring magnetic fields in the spatial volume to execute the steps of the method as claimed in one or more of claims 9 to 17, the display and control input units and the units for controlling and processing the Magnetic Resonance imaging apparatus, being controlled by programs loaded for executing said steps as claimed in one or more of claims 9 to 17.

22. A method as claimed in one or more of the preceding claims, **characterized in that** it compensates for peaks or fast variations of noise fields, which are modified by the currents generated in the electrically conductive structures around the magnetic cavity, the curve of said noise fields being equated to exponential field curve functions, which are used to calculate the inverse exponential compensation field curve functions, hence the currents for generating compensation field for fast transients of the noise field, which currents may be superimposed on or combined with the currents for generating compensation fields for noise fields having variations in one or more low-frequency bands.

23. A device for compensating for magnetic noise fields in a spatial volume and for implementing the method as claimed in one or more of the preceding claims 1 to 22, which includes:
At least one noise field detecting probe (S1, S2, S3, S4, S5, S6), which probes (S1, S2, S3, S4, S5, S6) are disposed outside a spatial volume (V);
At least one unit (2) for determining the magnetic fields inside the spatial volume, on the basis of the data detected by the probe/s (S1, S2, S3, S4, S5, S6) and/or of empirically defined or theoretically electrodynamics-based calculation or correlation functions.
At least one unit (3) for generating the magnetic compensation fields for the noise fields inside the spatial volume (V),
**characterized in that**
said device further includes means (4) for defining at least one separating frequency to discriminate at least two bands of noise fields, and means (2) for determining the corresponding magnetic fields inside the spatial volume (V) and/or means (3) for generating the corresponding compensation fields, at least some of which are different for at least some of the noise fields of said at least two frequency bands.

24. A device as claimed in claim 23, **characterized in that** it includes a set of filters (4), whose passband is such as to divide a frequency range into at least two different frequency bands or into three or more frequency bands.

25. A device as claimed in claim 23 or 24, **characterized in that** separate and different means (2) for determining the magnetic noise fields inside the volume (V), operating with at least partly different functions, are provided for all or some frequency bands (4) of the magnetic noise fields or for subsets of frequency bands.

26. A device as claimed in one or more of the preceding claims 23 to 25, **characterized in that**, alternatively to or in combination with the above, separate and different means (3) for generating compensation fields are provided for each frequency band or for subsets of frequency bands.

27. A device as claimed in one or more of the preceding claims 23 to 26, **characterized in that** it has a single probe (S1, S2, S3, S4, S5, S6) outside the spatial volume, which is connected to a single computer unit (2) for determining the noise field inside the spatial volume (V) and to a single unit (3) for generating the compensation field.

28. A device as claimed in one or more of the preceding claims 23 to 27, **characterized in that** it has a single probe (S1, S2, S3, S4, S5, S6) outside the spatial volume (V), which is connected to a single computer unit (2) for determining the noise field inside the spatial volume (V), said computer unit (2) being connected to a plurality of generator units (3) for generating compensation fields, all or some of the latter being associated to one of the at least two, three or more predetermined noise field frequency bands, the probe (S1, S2, S3, S4, S5, S6) being used in succession for detecting noise fields with frequencies in the range of the at least two, three or more predetermined frequency bands, there being provided variable passband filtering means (4), or different filters (4) with different passbands, for alternate connection to the probe (S1, S2, S3, S4, S5, S6), and the computer unit (2) for determining the noise fields inside the spatial volume (V) being programmable and provided with a storage unit containing the different functions for calculation of noise fields inside the spatial volume (V), on the basis of the noise fields detected by the probe (S1, S2, S3, S4, S5, S6) outside the spatial Volume (V), and for correlation between the noise fields outside the spatial volume (V) and the corresponding fields inside the spatial volume (V), whereas the algorithms of said calculation and correlation functions to determine and correlate magnetic fields inside the spatial volume (V), corresponding to all or some of the passbands of the filter (4) are loaded and executed in the working storage, in synchronism with the detection of outside noise fields in the range of a corresponding band among said frequency bands, whereas the inside noise field data as determined thereby is transmitted to a compensation field generator (3), dedicated to the corresponding frequency band.

29. A device as claimed in one or more of the preceding claims 23 to 26 and 27 or 28, **characterized in that** it has multiple permanent probes (S1, S2, S3, S4, S5, S6), each dedicated to the detection of noise fields outside the spatial volume (V), with frequencies in the range of one of the predetermined frequency bands or a subset of the predetermined frequency bands, a unit (2) for calculation or correlation of inside noise fields for each predetermined frequency band or subset of predetermined frequency bands, as well as a compensation field generator unit for each frequency band or each subset of frequency bands.

30. A device as claimed in one or more of the preceding claims 23 to 26 and 29, **characterized in that** the compensation field generating unit/s (3) include an electronic unit which generates a current to operate one or more magnetic field generating coils (B1, B2, B3, B4; 13, 14, 15), such as solenoids or the like, although a single compensation field generating coil may be provided, which is or may be connected to all or some of the different units (3) for generating compensation field exciting currents for the noise fields with frequencies in the range of the at least two, three or more predetermined frequency bands.

31. A device as claimed in one or more of the preceding claims 23 to 26 and 29 or 30, **characterized in that** the compensation field generating unit/s (3) include an electronic unit which generates a current to operate one or more magnetic field generating coils (B1, B2, B3, B4; 13, 14, 15), such as solenoids or the like, although a compensation field generating coil is provided, for all units (3) for generating compensation field exciting currents or for subsets thereof, which coil is separate and associated to at least one of the at least two, three or more predetermined frequency bands, or to a subset of said at least two, three or more frequency bands.

32. A device as claimed in one or more of the preceding claims 23 to 26 and 29 to 31, **characterized in that** it has at least two, three or more probes (S1, S2, S3, S4, S5, S6), positioned outside the spatial volume (V) in different locations, and each designed to detect the noise field outside said spatial volume (V) at the different probe locations, with frequencies in the range of at least one frequency band of the at least two, three or more predetermined bands, an algorithm being loaded in the computer and correlation unit (2), for generating and solving a field describing system of equations, each equation consisting of the calculation or correlation function and of a noise field describing function applied to the data detected by one of said at least two, three or more probes (S1, S2, S3, S4, S5, S6), which solution of the system of equations provides all the noise field describing variable parameters.

33. A device as claimed in claim 32, **characterized in that** it includes a programmable processing unit, containing the programs for solving the systems of equations.

34. A device as claimed in one or more of the preceding claims 32 and 33, **characterized in that** it includes a number of measuring probes (S1, S2, S3, S4, S5, S6) which corresponds to the number of independent variable parameters of the noise field describing function.

35. A device as claimed in one or more of the preceding claims 23 to 26 and 29 to 34, **characterized in that** it has at least one probe or device (5) which measures the field inside the spatial volume (V), there being provided means (6) for comparing the noise field/s inside the spatial volume which are obtained by a calculation based on measured outside fields, and the fields inside the spatial volume (V) which are measured by the internal probes or device (5), as well as means (7, 9) for manually adjusting the parameters of the calculation and correlation functions and/or of compensation fields, to minimize the differences between the calculated inside fields and the actually measured inside fields.

36. A device as claimed in claim 35, **characterized in that** the probes or devices (5) situated inside the spatial volume are active probes or devices, i.e. generate a predetermined test field, whose characteristics are well-known and predetermined in a no-noise condition, while the comparator (6) receives the measures of said test field inside the spatial volume (V) and the nominal known values (8) of said test field and there being provided means (7, 8) for manually adjusting the parameters of the calculation, correlation, noise field description and compensation field generation functions to minimize or neutralize the differences between the known test field data and actual test field measurement data.

37. A device as claimed in one or more of the preceding claims 35 or 34, **characterized in that**, a device for exciting and detecting Magnetic Resonance echoes in a predetermined phantom is used as an inside field detection device.

38. A device as claimed in claim 37, **characterized in that** the device for detecting the field inside the spatial volume (V) includes means (12) for generating a static field inside a predetermined volume, a coil (13) for transmitting nuclear spin exciting pulses, a coil (16) for receiving echoes from said nuclear spins, and a phantom (F) having well-known response characteristics related to said Magnetic Resonance echoes, means for determining the frequency of said Magnetic Resonance echoes and means (6) for comparing said Magnetic resonance echo frequency with the well-known frequency, means (7, 9) for adjusting the parameters of the calculation or correlation function/s and/or of noise field describing functions and/or of the compensation field generators, to minimize or neutralize the difference resulting from the comparator output.

39. A device as claimed in one or more of the preceding claims 23 to 26 and 29 to 38, **characterized in that** it includes means for processing the actual static field characteristics from the received echo signals, actual data being compared with well-known nominal data in the comparator.

40. A device as claimed in claim 39, **characterized in that** it has means for determining the static test field distribution in time, on the basis of the frequency of Magnetic Resonance echo signals.

41. A device as claimed in one or more of the preceding claims 23 to 26 and 29 to 42, **characterized in that** means are provided for automatically making adjustments to the parameters of calculation or correlation functions and/or of compensation field exciting current generation, consisting of a feedback unit, which adjusts the parameters of calculation or correlation functions and/or the noise field describing function, and/or the characteristics of the compensation field generating current on the basis of the difference signal resulting from the comparator (6) and with the purpose of minimizing or neutralizing said differences.

42. A device as claimed in one or more of the preceding claims 23 to 26 and 29 to 43, **characterized in that** manual adjustment means may be alternatively or jointly provided i.e. control input means for adjusting the parameters of the calculation or correlation functions and/or the compensation field generating currents.

43. A device as claimed in one or more of the preceding claims 23 to 26 and 29 to 42, **characterized in that** it has means (7) for displaying the parameters or the curve of the test field and/or the outside noise fields and/or both theoretical or known and actual or measured inside fields, which means display said data in alternate, overlapped and/or tiled form, graphic interface means (9) of graphic input means through which controls are input, which change the aspect of the magnetic fields and/or the parameters thereof and means for univocal association of an adjustment to the parameters of the calculation and correlation functions and/or to the compensation field generating currents in response to the selected graphic changes.

44. A device as claimed in one or more of the preceding claims 23 to 26 and 29 to 43, **characterized in that** the means and units of the device may be units with a dedicated construction or computers, as well as small suitably programmed PCs, having interfaces for connection with the outside noise field and/or inside noise field measuring probes, and with the compensation field generating coils and/or with the test field generating and measuring devices, while the software for executing probe signal reading functions, and/or the algorithms for determining the calculation and correlation functions to determine inside noise fields, the algorithms for determining current generating functions to create compensation field generating currents, the algorithms for executing comparison functions, functions for automatic determination or manual setting of adjustments to the parameters of calculation and correlation functions and/or to compensation field exciting current generation functions, as well as the software for displaying and controlling the alphanumeric and graphic manual data input interfaces is loaded, in any combination or subcombination, in said computer or PC.

45. A device as claimed in one or more of the preceding claims 23 to 26 and 29 to 44, **characterized in that** it includes means for determining, in a given time, the maximum and minimum values of the noise field curve; means for setting said time; means for determining the average value, or offset, of the noise field, and means for subtracting said offset or average value of the noise field curve from the latter, as well as means for generating the compensation field from said noise field curve after subtraction of the offset or average value therefrom.

46. A device as claimed in one or more of the preceding claims 23 to 26 and 29 to 45, **characterized in that** it is provided in combination with a Magnetic Resonance imaging apparatus, which is contained in a delimited space, that forms the spatial volume (V), wherein the noise fields are to be compensated for, at least some of the operating units of the Magnetic Resonance apparatus being used to execute at least some of the functions of the device as claimed in one or more of the preceding claims 23 to 45, in combination with control programs, that may be loaded in the control and processing unit of said Magnetic Resonance imaging apparatus.

47. A device as claimed in one or more of the preceding claims 23 to 26 and 29 to 46, **characterized in that** a Magnetic Resonance apparatus is used as an internal probe for detecting the conditions of the magnetic field inside said space (V) based on the changes made to a well-known static field.

48. A device as claimed in one or more of the preceding claims 23 to 26 and 29 to 47, **characterized in that** the graphic processing and display section of the Magnetic Resonance imaging apparatus is used as a graphic processing and display unit to display the curve of the test magnetic field as obtained by actual measurement, and that associated to known and predetermined characteristics, and to make appropriate adjustments aimed at minimizing or neutralizing the differences between the actual test field and the test field having those known and predetermined characteristics, i.e. the nominal test field.

49. A Magnetic Resonance imaging apparatus which has a cavity for accommodating a body under examination or a part thereof, **characterized in that** it is integrated with a device for compensating for noise fields in said cavity (V);
the said device for compensating for magnetic noise fields in a spatial volume and for implementing the method as claimed in one or more of the preceding claims 1 to 22, includes:
At least one noise field detecting probe (S1, S2, S3, S4, S5, S6), which probes (S1, S2, S3, S4, S5, S6) are disposed outside a spatial volume (V) ;
At least one unit (2) for determining the magnetic fields inside the spatial volume, on the basis of the data detected by the probe/s (S1, S2, S3, S4, S5, S6) and/or of empirically defined or theoretically electrodynamics-based calculation or correlation functions.
At least one unit (3) for generating the magnetic compensation fields for the noise fields inside the spatial volume (V),
said device further includes means (4) for defiling at least one separating frequency to discriminate at least two bands of noise fields, and means (2) for determining the corresponding magnetic fields inside the spatial volume (V) and/or means (3) for generating the corresponding compensation fields, at least some of which are different for at least some of the noise fields of said at least two frequency bands.

50. An apparatus as claimed in claim 49, **characterized in that** the device for compensating for noise fields inside the cavity which accommodates the body under examination or the part thereof has characteristics as claimed in one or more of the preceding claims 24 to 49.

51. A Magnetic Resonance imaging apparatus as claimed in claim 49 or 50, **characterized in that** it has a cavity (V) for accommodating a body under examination or a part thereof, means (12) for generating a static field which permeates said cavity, at least one exciting pulse transmitting coil (15), at least one nuclear spin echo receiving coil (16), at least one static field compensation coil (13) and at least one gradient coil (14), and there being provided an electronic apparatus controlling unit (10) to operate the transmitting coil, the compensation coil and the gradient coil/s and which receives nuclear spin echo signals from the receiving coil, processes them and display the corresponding images, which apparatus has, integrated herewith, a device for compensating for noise fields inside the cavity (V) which accommodates the body under examination or a part thereof, there being provided at least one probe (S1, S2, S3, S4, S5, S6) for detecting said noise fields inside said cavity (V), means (2) for determining said noise fields inside said cavity (V) on the basis of outside measurements, by theoretically or empirically defined calculation or correlation or noise field describing functions, means (3) for generating compensation fields for the noise fields inside said cavity (V).

52. An apparatus as claimed in claim 51, **characterized in that** said means (2) for determining said noise fields inside said cavity (V) on the basis of outside measurements, by theoretically or empirically defined calculation or correlation or noise field describing functions, and said means (3) for generating compensation fields for the noise fields inside said cavity (V) are separate units, different from the specific control and processing units (10) of the Magnetic Resonance imaging apparatus, or some or all of them (2, 3) are existing units of the Nuclear Magnetic imagine apparatus, in combination with specific control programs to operate the units of the Magnetic Resonance imaging apparatus, like said means (2) for determining said noise fields inside said cavity (V) and/or said means (3) for generating compensation fields for the noise fields inside said cavity (V).

53. An apparatus as claimed in claim 52, **characterized in that** the compensation field generator means include the compensation coil/s (13) and/or the gradient coil/s (14).

54. An apparatus as claimed in one or more of the preceding claims 49 to 53, **characterized in that** it has a programmable control and processing unit (10) and all the means of the noise field compensation device are the electronic units of the Magnetic Resonance imaging apparatus, in combination with software for executing noise field and compensation field measurement and determination functions.

55. An apparatus as claimed in one or more of the preceding claims 49 to 54, **characterized in that** it has an input for at least one probe, preferably for at least two, three or more probes (S1 S2, S3, S4, S5, S6) for detecting fields outside the cavity (V) which accommodates the body under examination, and units for interfacing said probes with the control and processing unit (10) of the apparatus, while a program for executing the compensation procedure is loaded, which determines, by using preset calculation and correlation functions, the noise field inside the cavity (V) and the current for exciting the compensation coil (13) and/or gradient coil (14), to be superimposed on the currents (17, 18) for generating normal compensation and/or gradient fields to obtain noise field compensation fields.

56. An apparatus as claimed in one or more of the preceding claims 49 to 55, **characterized in that** it has an interface for connection with one or more probes (S1, S2, S3, S4, S5, S6), which interface has means (4) for setting frequency thresholds, to determine at least two different frequency bands of noise fields or filters having a passband that may be or is set on different frequency bands for separate measurement of noise fields having different frequencies.

57. An apparatus as claimed in one or more of the preceding claims 49 to 56, **characterized in that** it has individual hardware units or specific software programs loaded in the control and processing unit thereof, separate computer units (2) for determining noise fields inside the cavity (V), by using optimized calculation or correlation functions for each frequency band of the at least two frequency bands being used.

58. An apparatus as claimed in one or more of the preceding claims 49 to 57, **characterized in that** it has individual hardware units or specific software programs loaded in the control and processing unit thereof, separate generator units (3) for generating compensation fields for the noise fields inside the cavity (V) for each frequency band of the at least two frequency bands being used.

59. An apparatus as claimed in one or more of the preceding claims 49 to 58, **characterized in that** the separate units (3) for generating the compensation fields for the noise fields inside the cavity (V) for each frequency band of the at least two frequency bands being used consist of a single generator unit which generates currents for exciting a single compensation coil, or of multiple separate generator units (3) for each frequency band in use, which operate compensation.___-_, field generating coils (13, 14), individually or in separate sets.

60. An apparatus as claimed in one or more of the preceding claims 49 to 59, **characterized in that** the generator units (3), which generate currents for exciting substantially homogeneous or uniform compensation fields, at least inside the imaging cavity (V), operate the static field compensation coils (13) of the Magnetic Resonance imaging apparatus, whereas generator units are provided to compensate for non homogeneous or non uniform noise fields in said imagine cavity (V), which operate the gradient coils (14) or adjust gradient coil exciting currents to generate compensation fields for said non homogeneous or non uniform noise fields.

61. An apparatus as claimed in one or more of the preceding claims 49 to 60, **characterized in that** it has means for measuring the actual magnetic field inside the cavity, which consist of the static field generators (12), the exciting pulse transmitting coil/s (15), the nuclear spin echo receiving coils (16), as well as the control and processing unit (10) of the apparatus itself, there being provided a phantom (F) to be accommodated in the cavity (V) of the apparatus and a software program for measuring the actual field in the cavity, which program is loaded in and may be executed by the control and processing unit (10), and includes the steps of transmitting exciting pulses to the phantom in the cavity, receiving nuclear spin echoes from the phantom, determining the field curve inside the cavity from the received echoes, and comparing the received echo frequency and/or the actual inside field curve with the nominally or theoretically expected echo frequency and/or with the nominal or theoretically expected static field curve.

62. An apparatus as claimed in claim 61, **characterized in that** it includes dedicated hardware units or software programs loaded in the control and processing unit (10) for automatic or manual processing of correction signals to correct the inside noise field calculation functions on the basis of the detections performed by the probe/s outside the cavity and/or to correct the compensation field/s exciting currents.

63. An apparatus as claimed in claim 62, **characterized in that** it has means for graphically displaying the curve of the measured field and of the known field, and manual input means (9) to input correction parameters either alphanumerically and through graphic devices for adjusting the actual curve of the displayed field, which parameters are interpreted by the apparatus and transformed into appropriate control signals, there being provided dedicated hardware units or suitable software programs in the control and processing unit (10) of the apparatus.

64. An apparatus as claimed in one or more of the preceding claims 49 to 63, **characterized in that** it includes means for determining, in a given time, the maximum and minimum values of the noise field curve; means for setting said time; means for determining the average value, or offset, of the noise field, and means for subtracting said offset or average value of the noise field curve from the latter, as well as means for generating the compensation field from said noise field curve after subtraction of the offset or average value therefrom.

## Patentansprüche

1. Verfahren zum Kompensieren von Störmagnetfeldern in räumlichen Volumen, wobei das räumliche Volumen ein Bildgebungshohlraum einer MRI-Vorrichtung zur Aufnahme des Patientenkörpers oder eines Teils desselben in einem Raum ist, in dem die Vorrichtung untergebracht ist, aufweisend die folgenden Schritte:
Ermitteln der Stärke eines Magnetfeldes außerhalb des räumlichen Volumens;
Bestimmen, auf einer theoretischen Basis, d.h. gemäß den Gesetzen des Elektromagnetismus, oder auf einer empirischen Basis, die Korrelation zwischen dem Störfeld außerhalb des räumlichen Volumens und dem entsprechenden Störfeld innerhalb des räumlichen Volumens, oder Berechnen des Störfeldes innerhalb des räumlichen Volumens von der/den Messung/-en des Magnetfeldes außerhalb des räumlichen Volumens;
Erzeugen eines Kompensationsmagnetfeldes von dem theoretisch oder empirisch bestimmten Magnetfeld innerhalb des räumlichen Volumens, insbesondere zur Neutralisation des Störfeldes in dem räumlichen Volumen;
**dadurch gekennzeichnet, dass** das Verfahren weiter ein separates Erfassen von Störfeldern mit Frequenzen im Bereich von wenigstens zwei verschiedenen Frequenzbändern oder in drei oder mehreren verschiedenen Frequenzbändern, und das Ermitteln und/oder Erzeugen des entsprechenden Kompensationsfeldes für alle oder wenigstens einige der Störfelder mit Frequenzen im Bereich der wenigstens zwei, drei oder mehreren vorgegebenen Frequenzbänder umfasst, wobei das Kompensationsfeld für wenigstens einige der Störfelder der wenigstens zwei Frequenzbänder unterschiedlich ist.

2. Verfahren nach Anspruch 1, **dadurch gekennzeichnet, dass** wenigstens einige der Störfelder mit Frequenzen im Bereich der wenigstens zwei, drei oder mehreren Frequenzbänder dasselbe Korrelationsgesetz zum Korrelieren der Parameter des/der äußeren Störfeldes/Störfelder mit dem/den inneren Störfeld/-ern, oder dasselbe Korrelationsgesetz zum Berechnen der Störmagnetfelder innerhalb des räumlichen Volumens basierend auf der/den Messung/-en der Störfelder außerhalb des räumlichen Volumens, und/oder dasselbe Mittel zum Erzeugen der entsprechenden Kompensationsfelder für wenigstens einige der Störmagnetfelder mit Frequenzen im Bereich der wenigstens zwei, drei oder mehreren verschiedenen Frequenzbänder verwenden.

3. Verfahren nach Anspruch 1 oder 2, **dadurch gekennzeichnet, dass** Korrelationsgesetze bereitgestellt werden, um das/die außerhalb des räumlichen Volumens erfasste/-n Störmagnetfeld/-er mit dem/den entsprechenden Störmagnetfeld/-ern innerhalb des räumlichen Volumens zu korrelieren, und dass Rechengesetze bereitgestellt werden, um die letzteren Felder auf Basis der Messung der Störfelder außerhalb des räumlichen Volumens zu berechnen, wobei die Gesetze für wenigstens einige oder alle der Störmagnetfelder mit Frequenzen im Bereich der wenigstens zwei, drei oder mehreren verschiedenen Frequenzbänder unterschiedlich sind.

4. Verfahren nach einem oder mehreren der vorhergehenden Ansprüche, **dadurch gekennzeichnet, dass** als Alternative dazu oder in Kombination damit auch Mittel zum Erzeugen von Kompensationsmagnetfeldern vorgesehen sind, welche unterschiedlich für alle oder wenigstens zwei der wenigstens zwei, drei oder mehreren Frequenzbänder sind, die zum Unterscheiden der verschiedenen Störfeldtypen verwendet werden.

5. Verfahren nach einem oder mehreren der vorhergehenden Ansprüche, **dadurch gekennzeichnet, dass** als eine Alternative dazu oder in Kombination damit wenigstens eine gemeinsame Erfassungsmesssonde zum Erfassen des/der Störfeldes/Störfelder mit Frequenzen im Bereich von allen oder wenigstens einigen der wenigstens zwei, drei oder mehreren Frequenzbänder, oder dass wenigstens eine andere Messsonde für die Störfelder mit Frequenzen im Bereich von allen der wenigstens zwei, drei oder mehreren unterscheidenden Frequenzbänder vorgesehen ist.

6. Verfahren nach einem oder mehreren der vorhergehenden Ansprüche, **dadurch gekennzeichnet, dass** es ein selektives Erzeugen eines/von Kompensationsfeldes/Kompensationsfeldern für eine beliebige Störfeldfrequenz durch Optimierung von Störfelderfassung, des Korrelationsgesetzes zum Korrelieren des/der außerhalb des räumlichen Volumens erfassten Störfeldes/Störfelder mit dem/den Störfeld/-ern innerhalb desselben, oder der Rechengesetze zum Berechnen des/der Letzteren von den Messungen der äußeren Störfelder, und der Kompensationsfelderzeugung bereitstellt.

7. Verfahren nach einem oder mehreren der vorhergehenden Ansprüche, **dadurch gekennzeichnet, dass** es die Schritte des Bestimmens der Freiheitsgrade, d.h. der variablen Parameter der einzelnen Störfelder, und des Messens der Störfelder an einer Anzahl von verschiedenen Orten außerhalb des räumlichen Volumens umfasst, wobei diese Anzahl der Anzahl der Freiheitsgrade oder variablen Parameter entspricht, wobei ein Gleichungssystem auf Basis dieser verschiedenen Messungen erzeugt wird, dessen Gleichungen eine Anzahl von Funktionen zum Korrelieren mit dem Feld innerhalb des räumlichen Volumens oder zum Berechnen des inneren Feldes oder zum Beschreiben der Störfeldkurve haben, wobei die Anzahl gleich der der Messungen ist, und dessen Lösung es erlaubt, alle variablen Parameter des Störmagnetfeldes und der Funktionen zu dessen Beschreibung und/oder zum Korrelieren des Störfeldes innerhalb des räumlichen Volumens und/oder der Funktionen zum Berechnen des Störfeldes innerhalb des räumlichen Volumens zu ermitteln.

8. Verfahren nach Anspruch 7, **dadurch gekennzeichnet, dass** die zwei, drei oder mehreren Messungen an verschiedenen Orten außerhalb des räumlichen Volumens für alle oder wenigstens einige der Störmagnetfelder mit Frequenzen im Bereich der wenigstens zwei, drei oder mehreren vorgegebenen Frequenzbänder wiederholt werden.

9. Verfahren nach einem oder mehreren der vorhergehenden Ansprüche, **dadurch gekennzeichnet, dass** es alternativ hierzu oder in Kombination damit die Schritte des Ermittelns der Funktionen zum Korrelieren des/der Störfeldes/Störfelder außerhalb des räumlichen Volumens mit dem/den Störfeld/-ern innerhalb desselben, oder der Funktionen zum Berechnen des/der inneren Störfeldes/Störfelder basierend auf den Messungen des/der äußeren Störfeldes/Störfelder, und/oder des Ermittelns der Störfeld beschreibenden Funktionen, und/oder des Ermittelns von Kompensationsfeldern durch Kontrollmessungen von Magnetfeldern innerhalb des räumlichen Volumens umfasst.

10. Verfahren nach Anspruch 9, **dadurch gekennzeichnet, dass** es die Schritte des Messens des/der Störfeldes/Störfelder innerhalb des räumlichen Volumens, des Vergleichens des/der gemessenen inneren Störfeldes/Störfelder mit dem/denen, das/die auf Basis der Messungen von Störfeldern außerhalb des räumlichen Volumens ermittelt worden ist/sind, des Regulierens des/der variablen Parameters/Parameter der Funktionen zum Berechnen oder Beschreiben der Magnetfelder innerhalb des räumlichen Volumens und/oder der Kompensationsfelder umfasst, mit dem Ziel der Minimierung oder Neutralisation der während des Vergleichs ermittelten Unterschiede.

11. Verfahren nach Anspruch 9, **dadurch gekennzeichnet, dass** es das Erzeugen eines bekannten statischen Testfeldes innerhalb des räumlichen Volumens und das Erfassen der momentanen Charakteristika des Testfeldes umfasst, wobei die Charakteristika mit den gut bekannten Charakteristika des statischen Testfeldes verglichen werden, wobei die variablen Parameter der das innere Feld und/oder das Kompensationsfeld berechnenden oder beschreibenden Funktionen reguliert werden, um die Unterschiede, welche von dem Vergleich zwischen gemessenen Charakteristika und gut bekannten Charakteristika des statischen Testfeldes resultieren, zu minimieren oder neutralisieren.

12. Verfahren nach Anspruch 11, **dadurch gekennzeichnet, dass** es die folgenden Schritte umfasst:
Erzeugen eines statischen Magnetfeldes in dem räumlichen Volumen, welches Magnetfeld eine solche Stärke und Homogenität hat, dass es zur Kernspinresonanztomographie geeignet ist;
Einführen eines Phantoms in das statische Magnetfeld, dessen Reaktion auf Kernspinanregung bekannt ist;
Anregen von Kernspinechos in dem Phantom durch Senden von Anregungsimpulsen zu diesem;
Empfangen von Kernspinechos von dem Phantom, wenn Felder zur Kompensation der Störfelder innerhalb des räumlichen Volumens bereitgestellt sind;
Vergleichen der empfangenen Daten mit gut bekannten Daten oder den Charakteristika des statischen Testfeldes, wie sie von empfangenen Signalen mit bekannten Charakteristika ermittelt worden sind;
Regulieren der Parameter der Funktionen, die zum Korrelieren des/der Störfeldes/Störfelder außerhalb des räumlichen Volumens mit dem/den Störfeld/-ern innerhalb des räumlichen Volumens oder zum Berechnen letzterer verwendet werden, oder der Parameter der Störfeld oder Kompensationsfeld beschreibenden Funktionen auf der Basis der vom obigen Vergleich resultierenden Unterschiede und auf die Art und Weise, dass diese Unterschiede neutralisiert oder minimiert werden.

13. Verfahren nach einem oder mehreren der Ansprüche 9 bis 12, **dadurch gekennzeichnet, dass** die Regulierung der Parameter der das innere Störfeld und/oder das Kompensationsfeld beschreibenden oder berechnenden Funktionen manuell durch eine alphanumerische Dateneingabe und/oder durch Steuerungen ermittelt wird, welche zum graphischen Wechseln der Vergleichsresultate vorgesehen sind.

14. Verfahren nach einem oder mehreren der Ansprüche 9 bis 12, **dadurch gekennzeichnet, dass** die Regulierung der Parameter der das innere Störfeld und/oder das Kompensationsfeld beschreibenden oder berechnenden Funktionen automatisch ermittelt wird.

15. Verfahren nach Anspruch 12, **dadurch gekennzeichnet, dass** ein Phantom in das statische Magnetfeld einer MRI-Vorrichtung eingeführt wird und dass die Frequenzreaktion von Kernspinechos, die in dem Phantom angeregt worden sind, analysiert werden, und dass der Unterschied zwischen der erfassten Frequenz und der theoretisch gut bekannten Phantomfrequenzreaktion zum Regulieren der Parameter von das innere Störfeld korrelierenden oder berechnenden Funktionen, und/oder von das Störfeld und/oder das Kompensationsfeld beschreibenden Funktionen, insbesondere zum Regulieren der Verstärkung von Kompensationsfelderzeugern verwendet wird.

16. Verfahren nach einem oder mehreren der Ansprüche 9 bis 15, **dadurch gekennzeichnet, dass** die Vergleichsresultate in graphischer Form auf einem Monitor dargestellt werden, wobei graphische Mittel zum Wechsel der angezeigten Darstellung vorgesehen sind, welche automatisch eine Steuerung zum Korrigieren der Parameter der das innere Störfeld berechnenden oder korrelierenden Funktionen, und/oder der das Störfeld und/oder das Kompensationsfeld beschreibenden Funktionen entsprechend graphischen Wechseln erzeugen.

17. Verfahren nach einem oder mehreren der vorhergehenden Ansprüche 9 bis 16, **dadurch gekennzeichnet, dass** die Schritte des Ermittelns der Funktionen zum Korrelieren des/der Störfeldes/Störfelder außerhalb des räumlichen Volumens mit dem/den Störfeld/-ern innerhalb desselben, oder der Funktionen zum Berechnen des/der inneren Störfeldes/Störfelder basierend auf Messungen des/der äußeren Störfeldes/Störfelder, und/oder des Ermittelns der Störfeld beschreibenden Funktionen, und/oder des Ermittelns der Kompensationsfelder durch Kontrollmessungen von Magnetfeldern innerhalb des räumlichen Volumens separat für jedes oder wenigstens einige der vorgegebenen wenigstens zwei, drei oder mehreren vorgegebenen Frequenzbänder ausgeführt werden, die zum Unterscheiden der Störmagnetfelder verwendet werden.

18. Verfahren nach einem oder mehreren der vorhergehenden Ansprüche, **dadurch gekennzeichnet, dass** es die folgenden Schritte umfasst:
Durchführen einer Vielzahl von Störfelderfassungen in der Zeit;
Ermitteln der Maximal- und Minimalwerte der Störfeldkurve in einer gegebenen Zeit;
Ermitteln des Kompensationsfeldes von dem gemäß Obigem gemessenen Störfeld durch Subtraktion des erfassten Offset- oder mittleren Störfeldwertes davon;
Erzeugen des Kompensationsfeldes für das Störfeld, von dem der erfasste Offset- oder mittlere Störfeldwert subtrahiert worden ist.

19. Verfahren zum Kompensieren von Störfeldern in räumlichen Volumen, wie beispielsweise Kernspintomographie-Vorrichtungen beinhaltende Räume, nach einem oder mehreren der vorhergehenden Ansprüche, **dadurch gekennzeichnet, dass** es das Erfassen eines/von Störfeldes/Störfeldern außerhalb des die Kernspintomographie-Vorrichtung beinhaltenden Raums, und das Verwenden der Steuer- und Verarbeitungseinheiten der Kernspintomographie-Vorrichtung zum Ausführen der Prozeduren einer/von Lesemessung/-en, und/oder das Berechnen des/der inneren Störfeldes/Störfelder, und/oder des Bestimmens der wenigstens zwei oder mehreren vorgegebenen Frequenzbänder, und/oder des Erzeugens von Kompensationsfeld erzeugenden Strömen, wobei eine oder mehrere Spulen zum Erzeugen des/der Kompensationsfeldes/Kompensationsfelder innerhalb des Raums, in dem die Kernspintomographie-Vorrichtung angeordnet ist, und Programme zur Steuerung von Steuerungs- und Verarbeitungseinheiten der Kernspintomographie-Vorrichtung umfasst, um die Schritte des Störfeldkompensationsverfahrens nach einem oder mehreren der vorhergehenden Ansprüche 1 bis 18 auszuführen.

20. Verfahren nach einem oder mehreren der vorhergehenden Ansprüche, **dadurch gekennzeichnet, dass** das räumliche Volumen, in dem die Störfelder kompensiert werden sollen, ein Hohlraum der Kernspintomographie-Vorrichtung ist, welcher einen zu untersuchenden Körper oder einen Teil desselben beinhaltet.

21. Verfahren nach Anspruch 19 oder 20, **dadurch gekennzeichnet, dass** die Kernspintomographie-Vorrichtung ebenso eine Einrichtung zum Messen von Magnetfeldern in dem räumlichen Volumen ist, um die Schritte des Verfahrens nach einem oder mehreren der Ansprüche 9 bis 17 auszuführen, wobei die Anzeige- und Steuereingabeeinheiten und die Einheiten zum Steuern und Verarbeiten der Kernspintomographie-Vorrichtung durch Programme gesteuert werden, welche zum Ausführen dieser Schritte geladen sind, wie sie mit einem oder mehreren der Ansprüche 9 bis 17 beansprucht werden.

22. Verfahren nach einem oder mehreren der vorhergehenden Ansprüche, **dadurch gekennzeichnet, dass** es Peaks oder schnelle Schwankungen der Störfelder kompensiert, welche durch die Ströme, die in elektrisch leitenden Strukturen um den magnetischen Hohlraum erzeugt werden, modifiziert werden, wobei die Kurve der Störfelder mit exponentiellen Feldkurvenfunktionen gleichgesetzt werden, welche zum Berechnen von inversen exponentiellen Kompensationsfeldkurvenfunktionen verwendet werden, demzufolge der Ströme zum Erzeugen von Kompensationsfeldern für schnelle Transienten des Störfeldes, welche den Strömen zum Erzeugen von Kompensationsfeldern für Störfelder mit Schwankungen in einem oder mehreren Tieffrequenzbändern überlagert oder mit diesen kombiniert werden können.

23. Vorrichtung zum Kompensieren von Störmagnetfeldern in einem räumlichen Volumen und zum Durchführen des Verfahrens nach einem oder mehreren der vorhergehenden Ansprüche 1 bis 22, aufweisend:
wenigstens eine Störfelderfassungsmesssonde (S1, S2, S3, S4, S5, S6), welche Messsonden (S1, S2, S3, S4, S5, S6) außerhalb eines räumlichen Volumens (V) angeordnet sind;
wenigstens eine Einheit (2) zum Bestimmen des Magnetfeldes innerhalb des räumlichen Volumens auf Basis der mit der/den Messsonde/Messsonden (S1, S2, S3, S4, S5, S6) erfassten Daten und/oder auf Basis von empirisch bestimmten oder theoretischen, auf Elektrodynamik basierenden Berechnungs-oder Korrelationsfunktionen;
wenigstens eine Einheit (3) zum Erzeugen der Kompensationsmagnetfelder für die Störfelder innerhalb des räumlichen Volumens (V);
**dadurch gekennzeichnet, dass** die Vorrichtung weiter Mittel (4) zum Bestimmen wenigstens einer Separierungsfrequenz, um wenigstens zwei Bänder von Störfeldern zu unterscheiden, und Mittel (2) zum Ermitteln der entsprechenden Magnetfelder innerhalb des räumlichen Volumens (V), und/oder Mittel (3) zum Erzeugen der entsprechenden Kompensationsfelder umfasst, wobei wenigstens einige von diesen unterschiedlich für wenigstens einige der Störfelder der wenigstens zwei Frequenzbänder sind.

24. Vorrichtung nach Anspruch 23, **dadurch gekennzeichnet, dass** es einen Satz Filter (4) aufweist, deren Durchlassband derart ist, dass ein Frequenzbereich in wenigstens zwei verschiedene Frequenzbänder oder in drei oder mehr Frequenzbänder geteilt wird.

25. Vorrichtung nach Anspruch 23 oder 24, **dadurch gekennzeichnet, dass** separate und andere Mittel (2) zum Ermitteln des Störmagnetfeldes innerhalb des Volumens (V) für alle oder einige Frequenzbänder (4) der Störmagnetfelder oder für Teilsätze von Frequenzbändern vorgesehen sind, welche mit wenigstens teilweise unterschiedlichen Funktionen operieren.

26. Vorrichtung nach einem oder mehreren der vorhergehenden Ansprüche 23 bis 25, **dadurch gekennzeichnet, dass** alternativ oder in Kombination mit dem Obigen separate und andere Mittel (3) zum Erzeugen von Kompensationsfeldern für jedes Frequenzband oder für Teilsätze von Frequenzbändern vorgesehen sind.

27. Vorrichtung nach einem oder mehreren der vorhergehenden Ansprüche 23 bis 26, **dadurch gekennzeichnet, dass** sie eine einzige Messsonde (S1, S2, S3, S4, S5, S6) außerhalb des räumlichen Volumens aufweist, welche mit einer einzelnen Computereinheit (2) zum Ermitteln des Störfeldes innerhalb des räumlichen Volumens (V) und mit einer einzelnen Einheit (3) zum Erzeugen des Kompensationsfeldes verbunden ist.

28. Vorrichtung nach einem oder mehreren der vorhergehenden Ansprüche 23 bis 27, **dadurch gekennzeichnet, dass** es eine einzelne Messsonde (S1, S2, S3, S4, S5, S6) außerhalb des räumlichen Volumens (V) aufweist, welche mit einer einzelnen Computereinheit (2) zum Ermitteln des Störfeldes innerhalb des räumlichen Volumens (V) verbunden ist, wobei die Computereinheit (2) mit einer Vielzahl von Erzeugungseinheiten (3) zum Erzeugen von Kompensationsfeldern verbunden ist, wobei alle oder einige der letzteren einem der wenigstens zwei, drei oder mehreren vorgegebenen Störfeldfrequenzbändern zugeordnet sind, wobei die Messsonde (S1, S2, S3, S4, S5, S6) zum nacheinander folgenden Erfassen von Störfeldern mit Frequenzen im Bereich der wenigstens zwei, drei oder mehreren vorgegebenen Frequenzbänder verwendet wird, wobei Filtermittel (4) mit variablem Durchlassband oder verschiedene Filter (4) mit verschiedenen Durchlassbändern zum abwechselnden Verbinden mit der Messsonde (S1, S2, S3, S4, S5, S6) vorgesehen sind, und wobei die Computereinheit (2) zum Ermitteln der Störfelder innerhalb des räumlichen Volumens (V) programmierbar ist und mit einer Speichereinheit versehen ist, die die verschiedenen Funktionen zum Berechnen der Störfelder innerhalb des räumlichen Volumens (V) auf der Basis der Störfelder, welche durch die Messsonde (S1, S2, S3, S4, S5, S6) außerhalb des räumlichen Volumens (V) erfasst worden sind, und zum Korrelieren der Störfelder außerhalb des räumlichen Volumens (V) mit den entsprechenden Feldern innerhalb des räumlichen Volumens (V) beinhaltet, wobei die Algorithmen der Berechnungs- und Korrelationsfunktionen zum Ermitteln und Korrelieren von Magnetfeldern innerhalb des räumlichen Volumens (V), welche zu allen oder einigen der Durchlassbänder der Filter (4) gehören, in den Arbeitsspeicher geladen und synchron mit dem Erfassen von äußeren Störfeldern im Bereich eines entsprechenden Bandes unter den Frequenzbändern ausgeführt werden, wobei die inneren Störfelddaten, welche dabei ermittelt werden, an einen Kompensationsfelderzeuger (3) gesendet werden, welcher dem entsprechenden Frequenzband zugeordnet ist.

29. Vorrichtung nach einem oder mehreren der vorhergehenden Ansprüche 23 bis 26 und 27 oder 28, **dadurch gekennzeichnet, dass** es eine Vielzahl von ständigen Messsonden (S1, S2, S3, S4, S5, S6), von denen jede zum Erfassen von Störfeldern außerhalb des räumlichen Volumens (V) mit Frequenzen im Bereich von einem oder den vorgegebenen Frequenzbändern oder eines Teilsatzes der vorgegebenen Frequenzbänder bestimmt ist, eine Einheit (2) zum Berechnen und Korrelieren von inneren Störfeldern für jedes vorgegebene Frequenzband oder einen Teilsatz von vorgegebenen Frequenzbändern, sowie eine Kompensationsfeld erzeugende Einheit für jedes Frequenzband oder jeden Teilsatz von Frequenzbändern aufweist.

30. Vorrichtung nach einem oder mehreren der vorhergehenden Ansprüche 23 bis 26 und 29, **dadurch gekennzeichnet, dass** die Kompensationsfeld erzeugende/-n Einheit/-en (3) eine elektronische Einheit umfasst/umfassen, welche einen Strom erzeugt, um eine oder mehrere Magnetfeld erzeugende Spulen (B1, B2, B3, B4, 13, 14, 15), wie beispielsweise Solenoidspulen oder dergleichen, zu betreiben, wenngleich auch eine einzelne Kompensationsfeld erzeugende Spule vorgesehen sein kann, welche mit allen oder einigen der verschiedenen Einheiten (3) zum Erzeugen von Kompensationsfeld anregenden Strömen für die Störfelder mit Frequenzen im Bereich der wenigstens zwei, drei oder mehreren vorgegebenen Frequenzbänder verbunden ist oder verbunden sein kann.

31. Vorrichtung nach einem oder mehreren der vorhergehenden Ansprüche 23 bis 26 und 29 oder 30, **dadurch gekennzeichnet, dass** die Kompensationsfeld erzeugende/-n Einheit/-en (3) eine elektronische Einheit umfassen, welche einen Strom erzeugt, um eine oder mehrere Magnetfeld erzeugende Spulen (B1, B2, B3, B4, 13, 14, 15), wie beispielsweise Solenoidspulen oder dergleichen, zu betreiben, wenngleich eine Kompensationsfeld erzeugende Spule für alle Einheiten (3) zum Erzeugen von Kompensationsfeld anregenden Strömen oder für Teilsätzen davon vorgesehen ist, wobei die Spule separat ist und wenigstens einem der wenigstens zwei, drei oder mehreren vorgegebenen Frequenzbänder oder einem Teilsatz der wenigstens zwei, drei oder mehreren Frequenzbänder zugeordnet ist.

32. Vorrichtung nach einem oder mehreren der vorhergehenden Ansprüche 23 bis 26 und 29 bis 31, **dadurch gekennzeichnet, dass** sie wenigstens zwei, drei oder mehrere Messsonden (S1, S2, S3, S4, S5, S6) aufweist, die außerhalb des räumlichen Volumens (V) an verschiedenen Positionen angeordnet sind und von denen jede zum Erfassen des Störfeldes mit Frequenzen im Bereich von wenigstens einem Frequenzband der wenigstens zwei, drei oder mehreren vorgegebenen Bänder außerhalb des räumlichen Volumens (V) an verschiedenen Messprobenpositionen bestimmt ist, wobei ein Algorithmus in die Computer- und Korrelationseinheit (2) zum Erzeugen und Lösen eines ein Feld beschreibenden Gleichungssystems geladen ist, wobei jede Gleichung aus der Berechnungs- oder Korrelationsfunktion und einer ein Störfeld beschreibenden Funktion, welche auf die Daten, die durch eine der wenigstens zwei, drei oder mehr Messsonden (S1, S2, S3, S4, S5, S6) angewendet wird, besteht, wobei die Lösung des Gleichungssystems alle das Störfeld beschreibende variable Parameter liefert.

33. Vorrichtung nach Anspruch 32, **dadurch gekennzeichnet, dass** sie eine programmierbare Verarbeitungseinheit umfasst, welche die Programme zum Lösen des Gleichungssystems beinhaltet.

34. Vorrichtung nach einem oder mehreren der vorhergehenden Ansprüche 32 und 33, **dadurch gekennzeichnet, dass** sie eine Anzahl von Messsonden (S1, S2, S3, S4, S5, S6) aufweist, welche der Anzahl der unabhängigen variablen Parameter der das Störfeld beschreibenden Funktion entspricht.

35. Vorrichtung nach einem oder mehreren der vorhergehenden Ansprüche 23 bis 26 und 29 bis 34, **dadurch gekennzeichnet, dass** sie wenigstens eine Messsonde oder Einrichtung (5) aufweist, welche das Feld innerhalb des räumlichen Volumens (V) misst, wobei Mittel (6) zum Vergleichen des/der Störfeldes/Störfelder innerhalb des räumlichen Volumens, welches/welche aus einer Berechnung basierend auf gemessenen äußeren Feldern erhalten worden ist/sind, mit den Feldern innerhalb des räumlichen Volumens (V), welche durch die internen Messsonden oder Einrichtung (5) gemessen werden, sowie Mittel (7, 9) zum manuellen Regulieren der Parameter der Berechnungs- und Korrelationsfunktionen und/oder der Kompensationsfelder aufweist, um die Unterschiede zwischen den berechneten inneren Feldern und den momentanen gemessenen inneren Feldern zu minimieren.

36. Vorrichtung nach Anspruch 35, **dadurch gekennzeichnet, dass** die Messsonden oder Einheiten (5), welche innerhalb des räumlichen Volumens angeordnet sind, aktive Messsonden oder Einrichtungen sind, d.h., dass sie ein vorgegebenes Testfeld erzeugen, dessen Charakteristika in einer störfreien Umgebung gut bekannt und vorgegeben sind, während der Komparator (6) die Messungen des Testfeldes innerhalb des räumlichen Volumens (V) und die nominal bekannten Werte (8) des Testfeldes empfängt, und wobei Mittel (7, 8) zum manuellen Regulieren der Parameter der Berechnungs-, Korrelations-, Störfeld beschreibenden und Kompensationsfeld erzeugenden Funktionen vorgesehen sind, um die Unterschiede zwischen den bekannten Testfelddaten und den momentanen Testfelddatenmessungsdaten zu minimieren oder zu neutralisieren.

37. Vorrichtung nach einem oder mehreren der vorhergehenden Ansprüche 35 oder 34, **dadurch gekennzeichnet, dass** eine Einrichtung zum Anregen und Erfassen von Kernspinechos in einem vorgegebenen Phantom als Einrichtung zum Erfassen des inneren Feldes verwendet wird.

38. Vorrichtung nach Anspruch 37, **dadurch gekennzeichnet, dass** die Einrichtung zum Erfassen des Feldes innerhalb des räumlichen Volumens (V) Mittel (12) zum Erzeugen eines statischen Feldes innerhalb eines vorgegebenen Volumens, eine Spule (13) zum Aussenden von Kernspin anregenden Impulsen, eine Spule (16) zum Empfangen von Echos von den Kernspins, und ein Phantom (F) mit gut bekannten Reaktionscharakteristika bzgl. der Kernspinechos, Mittel zum Ermitteln der Frequenz der Kernspinechos, und Mittel (6) zum Vergleichen der Kernspinechofrequenz mit der gut bekannten Frequenz, Mittel (7, 9) zum Regulieren der Parameter der Berechnungs- oder Korrelationsfunktion/-en und/oder der Störfeld beschreibenden Funktionen und/oder der Kompensationsfelderzeuger aufweist, um den aus der Komparatorausgabe resultierenden Unterschied zu minimieren oder zu neutralisieren.

39. Vorrichtung nach einem oder mehreren der vorhergehenden Ansprüche 23 bis 26 und 29 bis 38, **dadurch gekennzeichnet, dass** sie Mittel zum Verarbeiten der momentanen Charakteristika des statischen Feldes von den empfangenen Echosignalen aufweist, wobei die momentanen Daten mit den gut bekannten nominalen Daten in dem Komparator verglichen werden.

40. Vorrichtung nach Anspruch 39, **dadurch gekennzeichnet, dass** sie Mittel zum Ermitteln der statischen Testfeldverteilung in der Zeit auf Basis der Frequenz der Kernspinechosignale aufweist.

41. Vorrichtung nach einem oder mehreren der vorhergehenden Ansprüche 23 bis 26 und 29 bis 42, **dadurch gekennzeichnet, dass** Mittel zum automatischen Durchführen von Regulierungen der Parameter von Berechnung-oder Korrelationsfunktionen und/oder von Kompensationsfeld anregender Stromerzeugung vorgesehen sind, bestehend aus einer Feedback-Einheit, welche die Parameter der Berechnung- oder Korrelationsfunktionen und/oder der das Störfeld beschreibenden Funktion und/oder der Charakteristika des Kompensationsfeld erzeugenden Stroms auf der Basis des von dem Komparator (6) resultierenden Unterschiedsignals reguliert, mit dem Ziel, diese Unterschiede zu minimieren oder zu neutralisieren.

42. Vorrichtung nach einem oder mehreren der vorhergehenden Ansprüche 23 bis 26 und 29 bis 43, **dadurch gekennzeichnet, dass** alternativ oder zusätzlich manuelle Reguliermittel vorgesehen sind, das heißt Steuereingabemittel zum Regulieren der Parameter der Berechnungs- oder Korrelationsfunktionen und/oder der Kompensationsfeld erzeugenden Ströme.

43. Vorrichtung nach einem oder mehreren der vorhergehenden Ansprüche 23 bis 26 und 29 bis 42, **dadurch gekennzeichnet, dass** sie Mittel (7) zum Anzeigen der Parameter oder der Kurve des Testfeldes und/oder der äußeren Störfelder und/oder sowohl der theoretischen oder bekannten und momentanen oder gemessenen inneren Felder, welche Mittel die Daten in abwechselnder, überlappender und/oder ziegelartiger Form anzeigen, graphische Schnittstellenmittel (9) von graphischen Eingabemitteln, durch die Steuerungen eingegeben werden, welche die Ansicht von Magnetfeldern und/oder von deren Parametern verändern, und Mittel zum eindeutigen Zuordnen einer Regulierung zu den Parametern der Berechnungs- und Korrelationsfunktionen und/oder zu den Kompensationsfeld erzeugenden Strömen in Reaktion auf die ausgewählten graphischen Wechsel aufweist.

44. Vorrichtung nach einem oder mehreren der vorhergehenden Ansprüche 23 bis 26 und 29 bis 43, **dadurch gekennzeichnet, dass** die Mittel und Einheiten der Vorrichtung Einheiten mit einer bestimmten Konstruktion oder Computer, wie beispielsweise kleine geeignete programmierte PCs, sind, welche Schnittstellen zum Verbinden mit den Messsonden des äußeren Störfeldes und/oder des inneren Störfeldes und mit den Kompensationsfeld erzeugenden Spulen und/oder mit den Testfeld erzeugenden und messenden Einrichtungen aufweisen, wobei die Software zum Ausführen der Messsondensignal-Lesefunktionen, und/oder die Algorithmen zum Ermitteln der Berechnungs- und Korrelationsfunktionen zum Ermitteln des inneren Störfeldes, die Algorithmen zum Ermitteln der Strom erzeugenden Funktionen zum Erzeugen von Kompensationsfeld erzeugenden Strömen, die Algorithmen zum Ausführen von Vergleichfunktionen, Funktionen zum automatischen Ermitteln oder manuellen Festlegen von Regulierungen der Parameter der Berechnungs-und Korrelationsfunktionen und/oder von Kompensationsfeld anregenden Stromerzeugungsfunktionen, sowie die Software zum Anzeigen und Steuern der alphanumerischen und graphischen manuellen Dateneingabeschnittstellen in irgendeiner Kombination oder Unterkombination in den Computer oder PC geladen wird.

45. Vorrichtung nach einem oder mehreren der vorhergehenden Ansprüche 23 bis 26 und 29 bis 44, **dadurch gekennzeichnet, dass** sie Mittel zum Ermitteln der Maximal- und Minimalwerte der Störfeldkurve in einer gegebenen Zeit, Mittel zum Festlegen dieser Zeit, Mittel zum Ermitteln des Mittelwertes, oder des Offsets, des Störfeldes, Mittel zum Subtrahieren des Offsets oder des Mittelwertes der Störfeldkurve von letzterer, sowie Mittel zum Erzeugen des Kompensationsfeldes von der Störfeldkurve nach Subtraktion des Offsets oder des Mittelwertes davon aufweist.

46. Vorrichtung nach einem oder mehreren der vorhergehenden Ansprüche 23 bis 26 und 29 bis 45, **dadurch gekennzeichnet, dass** sie in Kombination mit einer Kernspintomographie-Vorrichtung vorgesehen ist, welche in einem begrenzten Raum beinhaltet ist, der das räumliche Volumen (V) bildet, in dem die Störfelder zu kompensieren sind, wobei wenigstens einige Betriebseinheiten der Kernspintomographie-Vorrichtung zum Ausführen wenigstens einiger der Funktionen der Vorrichtung nach einem oder mehreren der vorhergehenden Ansprüche 23 bis 25 verwendet werden, in Kombination mit Steuerprogrammen, welche in die Steuerungs- und Verarbeitungseinheit der Kernspintomographie-Vorrichtung geladen sein können.

47. Vorrichtung nach einem oder mehreren der vorhergehenden Ansprüche 23 bis 26 und 29 bis 46, **dadurch gekennzeichnet, dass** eine Kernspintomographie-Vorrichtung als interne Messsonde zum Erfassen der Zustände des Magnetfeldes innerhalb des Volumens (V) verwendet wird, welches auf den Änderungen, welche bzgl. eines gut bekannten statischen Feldes gemacht worden sind, basiert.

48. Vorrichtung nach einem oder mehreren der vorhergehenden Ansprüche 23 bis 26 und 29 bis 47, **dadurch gekennzeichnet, dass** der graphische Verarbeitungs- und Anzeigeteil der Kernspintomographie-Vorrichtung als graphische Verarbeitungs- und Anzeigeeinheit verwendet wird, um die Kurve des Testmagnetfeldes, wie es durch momentane Messungen erhalten werden kann, anzuzeigen und bekannten und vorgegebenen Charakteristika zuzuordnen, und um geeignete Regulierungen zu machen, die auf die Minimierung oder Neutralisation der Unterschiede zwischen dem momentanen Testfeld und dem Testfeld gerichtet sind, welches diese bekannten und vorgegebenen Charakteristika aufweist, d.h. das nominale Testfeld.

49. Kernspintomographie-Vorrichtung mit einem Hohlraum zum Aufnehmen eines zu untersuchenden Körpers oder eines Teils davon, **dadurch gekennzeichnet, dass** sie eine Vorrichtung zum Kompensieren von Störfeldern in dem Hohlraum (V) beinhaltet;
wobei die Vorrichtung zum Kompensieren von Störmagnetfeldern in einem räumlichen Volumen und zum Durchführen des Verfahrens nach einem oder mehreren der vorhergehenden Ansprüche 1 bis 22 umfasst:
wenigstens eine Störfeld erfassende Messsonde (S1, S2, S3, S4, S5, S6), welche Messsonden (S1, S2, S3, S4, S5, S6) außerhalb eines räumlichen Volumens (V) angeordnet sind;
wenigstens eine Einheit (2) zum Ermitteln des Magnetfeldes innerhalb des räumlichen Volumens auf Basis der durch die Messsonde/-n (S1, S2, S3, S4, S5, S6) erfassten und/oder von empirisch bestimmten oder theoretischen, auf Elektrodynamik basierenden Berechnungs- oder Korrelationsfunktionen;
wenigstens eine Einheit (3) zum Erzeugen der Kompensationsmagnetfelder für die Störfelder innerhalb des räumlichen Volumens (V);
die Vorrichtung umfasst weiter Mittel (4) zum Bestimmen wenigstens einer Separierungsfrequenz zum Unterscheiden von wenigstens zwei Bändern von Störfeldern, und Mittel (2) zum Ermitteln der entsprechenden Magnetfelder innerhalb des räumlichen Volumens (V), und/oder Mittel (3) zum Erzeugen der entsprechenden Kompensationsfelder, wobei wenigstens einige dieser unterschiedlich für wenigstens einige der Störfelder der wenigstens zwei Frequenzbänder sind.

50. Kernspintomographie-Vorrichtung nach Anspruch 49, **dadurch gekennzeichnet, dass** die Vorrichtung zum Kompensieren von Störfeldern innerhalb des Hohlraums, welcher den zu untersuchenden Körper oder einen Teil desselben aufnimmt, gemäß einem oder mehreren der vorhergehenden Ansprüche 24 bis 49 **gekennzeichnet** ist.

51. Kernspintomographie-Vorrichtung nach Anspruch 49 oder 50, **dadurch gekennzeichnet, dass** sie einen Hohlraum (V) zum Aufnehmen eines zu untersuchenden Körpers oder eines Teils davon, Mittel (12) zum Erzeugen eines statischen Feldes, welches den Hohlraum durchdringt, wenigstens eine Anregungsimpulse aussendende Spule (15), wenigstens eine Kernspinechos empfangende Spule (16), wenigstens eine ein statisches Kompensationsfeld erzeugende Spule (13), und wenigstens eine Gradientenspule (14) aufweist, wobei eine elektronische die Kernspintomographie-Vorrichtung steuernde Einheit (10) zum Betreiben der Sendespule, der Kompensationsspule und der Gradientenspule/-n vorgesehen ist, die die Kernspinechosignale von der Empfangsspule empfängt, diese verarbeitet und entsprechende Bilder anzeigt, wobei die Kernspintomographie-Vorrichtung eine integrierte Vorrichtung zum Kompensieren von Störfeldern innerhalb des Hohlraums (V), welcher den zu untersuchenden Körper oder einen Teil davon aufnimmt, aufweist, wobei wenigstens eine Messsonde (S1, S2, S3, S4, S5, S6) zum Erfassen der Störfelder innerhalb des Hohlraums (V), Mittel (2) zum Ermitteln der Störfelder innerhalb des Hohlraums (V) auf Basis von äußeren Messungen durch theoretische oder empirisch bestimmte Berechnungs- oder Korrelations- oder Störfeld beschreibenden Funktionen, und Mittel (3) zum Erzeugen von Kompensationsfeldern für die Störfelder innerhalb des Hohlraums (V) vorgesehen sind.

52. Kernspintomographie-Vorrichtung nach Anspruch 51, **dadurch gekennzeichnet, dass** Mittel (2) zum Ermitteln der Störfelder innerhalb des Hohlraums (V) auf Basis von äußeren Messungen durch theoretische oder empirisch bestimmte Berechnungs- oder Korrelations- oder Störfeld beschreibenden Funktionen, und dass Mittel (3) zum Erzeugen von Kompensationsfeldern für die Störfelder innerhalb des Hohlraums (V) separate Einheiten sind, welche sich von speziellen Steuerungs- und Verarbeitungseinheiten (10) der Kernspintomographie-Vorrichtung unterscheiden, oder einige oder alle von diesen (2, 3) sind vorhandene Einheiten der Kernspintomographie-Vorrichtung, in Kombination mit speziellen Steuerungsprogrammen, um die Einheiten der Kernspintomographie-Vorrichtung, wie beispielsweise die Mittel (2) zum Ermitteln des Störfeldes innerhalb des Hohlraums (V) und/oder die Mittel (3) zum Erzeugen von Kompensationsfeldern für die Störfelder innerhalb des Hohlraums (V), zu betreiben.

53. Vorrichtung nach Anspruch 52, **dadurch gekennzeichnet, dass** die Kompensationsfelderzeugungsmittel die Kompensationsspule/-n (13) und/oder die Gradientspule/-n (14) umfassen.

54. Vorrichtung nach einem oder mehreren der vorhergehenden Ansprüche 49 bis 53, **dadurch gekennzeichnet, dass** sie eine programmierbare Steuerungs- und Verarbeitungseinheit (10) aufweist, und dass alle Mittel der Störfeldkompensationsvorrichtung elektronische Einheiten der Kernspintomographie-Vorrichtung sind, in Kombination mit Software zum Ausführen von Störfeld- und Kompensationsfeldmessungs- und - ermittlungsfunktionen.

55. Kernspintomographie-Vorrichtung nach einem oder mehreren der vorhergehenden Ansprüche 49 bis 54, **dadurch gekennzeichnet, dass** sie eine Eingabe für wenigstens eine Messsonde, vorzugsweise für wenigstens zwei, drei oder mehrere Messsonden (S1, S2, S3, S4, S5, S6) zum Erfassen von Feldern außerhalb des Hohlraums (V), welcher den zu untersuchenden Körper aufnimmt, und Einheiten zum Verbinden der Messsonden mit der Steuerungs-und Verarbeitungseinheit (10) der Kernspintomographie-Vorrichtung aufweist, während ein Programm zum Ausführen der Kompensationsprozedur geladen wird, das unter Verwendung von vorgegebenen Berechnungs- und Korrelationsfunktionen das Störfeld innerhalb des Hohlraums (V) und den Strom zum Anregen der Kompensationsspule (13) und/oder Gradientenspule (14) ermittelt, um den Strömen (17, 18) zum Erzeugen normaler Kompensation und/oder den Gradientfeldern überlagert zu werden, um Störfeldkompensationsfelder zu erhalten.

56. Vorrichtung nach einem oder mehreren der vorhergehenden Ansprüche 49 bis 55, **dadurch gekennzeichnet, dass** sie eine Schnittstelle zum Verbinden mit einer oder mehreren Messsonden (S1, S2, S3, S4, S5, S6) hat, wobei die Schnittstelle Mittel (4) zum Festlegen von Frequenzgrenzwerten, um wenigstens zwei verschiedene Frequenzbänder von Störfeldern zu ermitteln, oder Filter mit einem Durchlassband aufweist, das für verschiedene Frequenzbänder für eine separate Messung von Störfeldern, die verschiedene Frequenzen haben, festgelegt ist oder sein kann.

57. Kernspintomographie-Vorrichtung nach einem oder mehreren der vorhergehenden Ansprüche 49 bis 56, **dadurch gekennzeichnet, dass** sie einzelne Hardwareeinheiten oder spezielle in die Steuerungs- und Verarbeitungseinheit geladene Softwareprogramme, separate Computereinheiten (2) zum Ermitteln von Störfeldern innerhalb des Hohlraums (V) durch Verwenden von optimierten Berechnungs- oder Korrelationsfunktionen für jedes Frequenzband der wenigstens zwei verwendeten Frequenzbänder aufweist.

58. Kernspintomographie-Vorrichtung nach einem oder mehreren der vorhergehenden Ansprüche 49 bis 57, **dadurch gekennzeichnet, dass** sie einzelne Hardwareeinheiten oder spezielle in ihre Steuerungs- und Verarbeitungseinheit geladene Softwareprogramme und separate Erzeugungseinheiten (3) zum Erzeugen von Kompensationsfeldern für die Störfelder innerhalb des Hohlraums (V) für jedes Frequenzband der wenigstens zwei verwendeten Frequenzbänder aufweist.

59. Kernspintomographie-Vorrichtung nach einem oder mehreren der vorhergehenden Ansprüche 49 bis 58, **dadurch gekennzeichnet, dass** die separaten Einheiten (3) zum Erzeugen der Kompensationsfelder für die Störfelder innerhalb des Hohlraums (V) für jedes Frequenzband der wenigstens zwei verwendeten Frequenzbänder aus einer einzigen Erzeugungseinheit, welche Ströme zum Anregen einer einzigen Kompensationsspule erzeugt, oder aus einer Vielzahl von separaten Erzeugungseinheiten (3) für jedes verwendete Frequenzband besteht, welche Kompensationsfeld erzeugende Spulen (13, 14) betreiben, einzeln oder in separaten Gruppen.

60. Kernspintomographie-Vorrichtung nach einem oder mehreren der vorhergehenden Ansprüche 49 bis 59, **dadurch gekennzeichnet, dass** die Erzeugungseinheiten (3), welche Ströme zum Anregen von im Wesentlichen homogenen und uniformen Kompensationsfeldern zumindest innerhalb des Bildgebungshohlraums (V) erzeugen, die statischen Feldkompensationsspulen (13) der Kernspintomographie-Vorrichtung betreiben, wobei Erzeugungseinheiten zum Kompensieren von nicht-homogenen oder nichtuniformen Störfeldern in dem Bildgebungshohlraum (V) vorgesehen sind, welche die Gradientenspulen (14) betreiben oder Gradientenspulen anregende Ströme regulieren, um Kompensationsfelder für die nicht-homogenen oder nichtuniformen Störfelder zu erzeugen.

61. Kernspintomographie-Vorrichtung nach einem oder mehreren der vorhergehenden Ansprüche 49 bis 60, **dadurch gekennzeichnet, dass** sie Mittel zum Messen des momentanen Magnetfeldes innerhalb des Hohlraums aufweist, welche aus Erzeugern (12) eines statischen Feldes, der/den anregenden impulsaussendenden Spule/-n (15), den Kernspinecho empfangenden Spulen (16), sowie der Steuerungs- und Verarbeitungseinheit (10) der Kernspintomographie-Vorrichtung selber bestehen, wobei ein in den Hohlraum (V) aufzunehmendes Phantom (F) und ein Softwareprogramm zum Messen des momentanen Feldes in dem Hohlraum vorgesehen sind, welches Programm in die Steuerungs- und Verarbeitungseinheit (10) geladen ist und von dieser ausgeführt werden kann und welches die Schritte des Aussendens von Anregungsimpulsen an das Phantom in dem Hohlraum, des Empfangens der Kernspinechos des Phantoms, des Ermittelns der Feldkurve innerhalb des Hohlraums von den empfangenen Echos und des Vergleichens der empfangenen Echofrequenz und/oder der momentanen inneren Feldkurve mit der nominal oder theoretisch erwarteten Echofrequenz und/oder mit der nominal oder theoretisch erwarteten statischen Feldkurve umfasst.

62. Vorrichtung nach Anspruch 61, **dadurch gekennzeichnet, dass** sie bestimmte Hardwareeinheiten oder in die Steuerungs- und Verarbeitungseinheit (10) geladene Softwareprogramme zum automatischen oder manuellen Verarbeitung von Korrektursignalen umfasst, um die inneren Störfeldberechnungsfunktionen auf der Basis der mittels der Messsonde/-n außerhalb des Hohlraums durchgeführten Erfassungen zu korrigieren und/oder um die Kompensationsfeld/-er anregenden Ströme zu korrigieren.

63. Kernspintomographie-Vorrichtung nach Anspruch 62, **dadurch gekennzeichnet, dass** sie Mittel zum graphischen Anzeigen der Kurve des gemessenen Feldes und des bekannten Feldes, und ein manuelles Eingabemittel (9) zum Eingeben von Korrekturparametern entweder alphanumerisch und durch graphische Einrichtungen zum Regulieren der momentanen Kurve des angezeigten Feldes aufweist, welche Parameter durch die Kernspintomographie-Vorrichtung interpretiert und in geeignete Steuersignale umgeformt werden, wobei bestimmte Hardwareeinheiten oder geeignete Softwareprogramme in der Steuerungs- und Verarbeitungseinheit (10) der Kernspintomographie-Vorrichtung vorgesehen sind.

64. Kernspintomographie-Vorrichtung nach einem oder mehreren der vorhergehenden Ansprüche 49 bis 63, **dadurch gekennzeichnet, dass** sie Mittel zum Ermitteln der Maximal- und Minimalwerte der Störfeldkurve in einer gegebenen Zeit, Mittel zum Festlegen dieser Zeit, Mittel zum Ermitteln des Mittelwertes oder des Offsets des Störfeldes, Mittel zum Subtrahieren des Offsets oder des Mittelwertes der Störfeldkurve von letzterer, sowie Mittel zum Erzeugen des Kompensationsfeldes von der Störfeldkurve, nachdem der Offset oder der Mittelwert davon subtrahiert worden ist, aufweist.

## Revendications

1. Procédé de compensation de champs de bruit magnétique dans un volume d'espace, ledit volume d'espace étant la cavité d'imagerie d'un appareil d'IRM recevant le corps d'un patient ou une partie de celui-ci dans un local où ledit appareil est disposé, comprenant les étapes suivantes consistant à :
déterminer la force d'un champ magnétique en dehors dudit volume d'espace;
définir, sur une base théorique, à savoir selon les lois de l'électromagnétisme, ou sur une base empirique, la corrélation qui existe entre le champ de bruit en dehors du volume d'espace et le champ de bruit correspondant à l'intérieur dudit volume d'espace, ou calculer le champ de bruit à l'intérieur dudit volume d'espace, à partir de la ou des mesures du champ magnétique en dehors dudit volume d'espace;
à partir du champ magnétique à l'intérieur dudit volume d'espace, tel qu'il a été déterminé de manière théorique ou empirique, générer un champ de compensation magnétique, neutralisant en particulier le champ de bruit dans ledit volume d'espace;
**caractérisé en ce que:**
le procédé fournit en outre une détection séparée des champs de bruit avec des fréquences dans la plage d'au moins deux bandes de fréquences différentes, ou dans trois bandes de fréquences différentes ou plus, et la détermination et/ou la génération du champ de compensation correspondant pour tous les champs de bruit, ou au moins pour certains d'entre eux, avec des fréquences dans la plage au moins desdites deux, trois ou plus, bandes de fréquences prédéterminées, dans lequel ledit champ de compensation est différent pour au moins certains des champs de bruit desdites au moins deux bandes de fréquences.

2. Procédé selon la revendication 1, **caractérisé en ce que** au moins certains des champs de bruit avec des fréquences dans la plage des au moins deux, trois ou plus, bandes de fréquence, utilisent la même loi de corrélation afin de corréler les paramètres du ou des champs de bruit extérieurs avec un ou des champs de bruit intérieurs, ou la même loi de corrélation afin de calculer les champs de bruit magnétique à l'intérieur du volume d'espace, sur la base de la ou des mesures des champs de bruit en dehors du volume d'espace et/ou des mêmes moyens générant des champs de compensation correspondants pour au moins certains des champs de bruit magnétique avec des fréquences dans la plage au moins des deux, trois ou plus, bandes de fréquences différentes.

3. Procédé selon la revendication 1 ou la revendication 2, **caractérisé en ce que** les lois de corrélation sont fournies afin de corréler le ou les champs de bruit magnétique détectés en dehors du volume d'espace et le ou les champs de bruit magnétique correspondants à l'intérieur du volume d'espace, et **en ce que** des lois de calcul sont fournies de manière à calculer ces derniers champs, sur la base de la mesure des champs de bruit en dehors du volume d'espace, lesquelles lois sont différentes pour au moins certains des champs de bruit magnétique, voire tous, avec des fréquences dans la plage au moins des deux, trois ou plus, bandes de fréquences différentes.

4. Procédé selon l'une quelconque ou plusieurs des revendications précédentes, **caractérisé en ce que**, en remplacement de ces dernières ou en combinaison avec celles-ci, il est également possible de fournir des moyens générant des champs de compensation magnétique qui sont différents pour toutes les, ou pour certaines au moins des, au moins deux, trois ou plus, bandes de fréquences, qui sont utilisés pour discriminer les différents types de champ de bruit.

5. Procédé selon l'une quelconque ou plusieurs des revendications précédentes, **caractérisé en ce que**, en remplacement de ces dernières ou en combinaison avec celles-ci, il est possible de fournir au moins une sonde de détection commune détectant le ou les champs de bruit avec des fréquences dans la plage de toutes, ou de certaines au moins des au moins deux, trois ou plus, bandes de fréquences ou il est possible de fournir au moins une sonde différente pour les champs de bruit avec des fréquences dans la plage de toutes les au moins deux, trois ou plus, bandes de fréquence de discrimination.

6. Procédé selon l'une quelconque ou plusieurs des revendications précédentes, **caractérisé en ce qu'**il fournit une génération sélective du ou des champs de compensation pour n'importe quelle fréquence de champ de bruit, en optimisant la détection de champ de bruit, la loi de corrélation afin de corréler le ou les champs de bruit détectés en dehors du volume d'espace et le ou les champs de bruit à l'intérieur de celui-ci, ou les lois de calcul afin de calculer ces derniers à partir des mesures des champs de bruit en dehors, et une génération de champ de compensation.

7. Procédé selon l'une quelconque ou plusieurs des revendications précédentes, **caractérisé en ce qu'**il comprend les étapes consistant à définir les degrés de liberté, à savoir les paramètres variables des champs de bruit individuels, et à mesurer les champs de bruit en un certain nombre d'endroits différents, en dehors du volume d'espace, lequel nombre correspond au nombre de degrés de liberté ou de paramètres variables, un système d'équations étant généré sur la base de ces différentes mesures, lesquelles équations présentent un nombre de fonctions de corrélation avec le champ à l'intérieur du volume d'espace, ou de calcul dudit champ à l'intérieur ou de description de la courbe de champ de bruit, lequel nombre est égal à celui des mesures, et dont la solution permet de déterminer tous les paramètres variables du champ de bruit magnétique et des fonctions le décrivant et/ou corrélant le champ de bruit à l'intérieur du volume d'espace et/ou des fonctions calculant ledit champ de bruit à l'intérieur du volume d'espace.

8. Procédé selon la revendication 7, **caractérisé en ce que** les deux, trois ou plus, mesures effectuées en différents endroits en dehors du volume d'espace sont répétées pour tous les champs de bruit, ou pour au moins certains de ceux-ci, qui présentent des fréquences dans la plage desdits au moins deux, trois ou plus, bandes de fréquence prédéterminées.

9. Procédé selon l'une quelconque ou plusieurs des revendications précédentes, **caractérisé**, en remplacement de ces dernières ou en combinaison avec celles-ci, en ce qu'il comprend les étapes consistant à déterminer les fonctions de corrélation entre le ou les champs de bruit en dehors du volume d'espace et le ou les champs de bruit à l'intérieur de celui-ci, ou les fonctions de calcul du ou des champs de bruit à l'intérieur sur la base des mesures du ou des champs de bruit en dehors et/ou à déterminer les fonctions de description de champ de bruit et/ou à déterminer les champs de compensation par des mesures de contrôle des champs magnétiques à l'intérieur du volume d'espace.

10. Procédé selon la revendication 9, **caractérisé en ce qu'**il comprend les étapes consistant à mesurer le ou les champs de bruit à l'intérieur du volume d'espace, à comparer le ou les champs de bruit intérieurs mesurés à celui/à ceux déterminés sur la base des mesures des champs de bruit en dehors du volume d'espace, à régler le ou les paramètres variable desdites fonctions calculant ou décrivant les champs magnétiques à l'intérieur du volume d'espace et/ou les champs de compensation, en vue de minimiser ou de neutraliser les différences telles qu'elles ont été déterminées au cours de la comparaison.

11. Procédé selon la revendication 9, **caractérisé en ce qu'**il comprend la génération d'un champ de test statique connu à l'intérieur du volume d'espace, et la détection des caractéristiques réelles dudit champ de test, tandis que lesdites caractéristiques sont comparées avec les caractéristiques bien connues dudit champ de test statique, les paramètres variables desdites fonctions de calcul ou de description du champ intérieur et/ou du champ de compensation étant réglées de manière à minimiser ou à neutraliser les différences qui résultent de la comparaison entre les caractéristiques mesurées et les caractéristiques bien connues du champ de test statique.

12. Procédé selon la revendication 11, **caractérisé en ce qu'**il comprend les étapes suivantes consistant à :
générer un champ magnétique statique dans le volume d'espace, lequel champ magnétique présente une force et une homogénéité telles qu'il soit approprié à une imagerie par résonance magnétique;
introduire un fantôme dans ledit champ magnétique statique, dont la réponse à une excitation d'écho de spin nucléaire est connue ;
exciter des échos de spin nucléaire dans ledit fantôme, en lui transmettant des impulsions d'excitation;
recevoir des échos de spin nucléaire en provenance dudit fantôme lorsque sont fournis des champs compensant les champs de bruit dans le volume d'espace;
comparer les données reçues avec les données bien connues ou les caractéristiques du champ de test statique telles qu'elles ont été déterminées à partir des signaux reçus qui présentent des caractéristiques connues ;
régler les paramètres des fonctions qui sont utilisées pour calculer ou corréler le ou les champs de bruit en dehors du volume d'espace et le ou les champs de bruit à l'intérieur du volume d'espace, ou les paramètres des fonctions de description du champ de bruit ou du champ de compensation, sur la base des différences qui résultent de la comparaison ci-dessus, et d'une manière telle que soient neutralisées ou minimisées lesdites différences.

13. Procédé selon l'une quelconque ou plusieurs des revendications 9 à 12, **caractérisé en ce que** le réglage des paramètres des fonctions de description, ou de calcul du champ de bruit intérieur et/ou du champ de compensation, est déterminé manuellement, par l'entrée de données alphanumériques et/ou par des commandes conçues afin de changer graphiquement les résultats de la comparaison.

14. Procédé selon l'une quelconque ou plusieurs des revendications 9 à 12, **caractérisé en ce que** le réglage des paramètres des fonctions de description ou de calcul du champ de bruit intérieur et/ou du champ de compensation est déterminé automatiquement.

15. Procédé selon la revendication 12, **caractérisé en ce qu'**un fantôme est introduit dans le champ magnétique statique d'un appareil d'IRM et que la réponse en fréquence des échos de spin nucléaire excités dans ledit fantôme est analysée, et la divergence entre la fréquence détectée et la réponse en fréquence bien connue théorique du fantôme est utilisée afin de régler les paramètres des fonctions de corrélation ou de calcul du champ de bruit intérieur et/ou des fonctions de description de champ de bruit et/ou du champ de compensation, en particulier, le gain des générateurs de champ de compensation.

16. Procédé selon l'une quelconque ou plusieurs des revendications 9 à 15, **caractérisé en ce que** les résultats de la comparaison sont affichés sous une forme graphique sur un moniteur, des moyens graphiques étant fournis afin de changer la représentation affichée, lesquels moyens génèrent automatiquement des commandes corrigeant les paramètres des fonctions de calcul ou de corrélation du champ de bruit intérieur et/ou des fonctions de description de champ de bruit et/ou de champ de compensation, qui correspondent aux changements graphiques.

17. Procédé selon l'une quelconque ou plusieurs des revendications 9 à 16 précédentes, **caractérisé en ce que** les étapes consistant à déterminer les fonctions de corrélation entre le ou les champs de bruit en dehors du volume d'espace et le ou les champs de bruit à l'intérieur de celui-ci, ou les fonctions de calcul du ou des champs de bruit à l'intérieur sur la base des mesures du ou des champs de bruit en dehors, et/ou à déterminer les fonctions de description de champ de bruit, et/ou à déterminer les champs de compensation par des mesures de contrôle des champs magnétiques à l'intérieur du volume d'espace, sont exécutées séparément pour chacune ou au moins pour plusieurs des au moins deux, trois ou plus, bandes de fréquences prédéterminées utilisées pour discriminer les champs de bruit magnétique.

18. Procédé selon l'une quelconque ou plusieurs des revendications précédentes, **caractérisé en ce qu'**il comprend les étapes suivantes consistant à :
exécuter de multiples détections de champ de bruit au cours du temps ;
déterminer, dans un temps donné, les valeurs maximum et minimum de la courbe de champ de bruit ;
déterminer le champ de compensation à partir du champ de bruit tel qu'il a été mesuré selon ce qui précède, en soustrayant de celui-ci la valeur de décalage ou de champ de bruit détecté moyenne ;
générer le champ de compensation dudit champ de bruit, duquel est soustraite la valeur de décalage ou de champ de bruit détecté moyenne.

19. Procédé de compensation de champs de bruit dans des volumes d'espace tels que des locaux qui contiennent des appareils d'imagerie par résonance magnétique, selon l'une quelconque ou plusieurs des revendications précédentes, **caractérisé en ce qu'**il comprend la détection du ou des champs de bruit en dehors du local qui contient l'appareil d'imagerie par résonance magnétique, et l'utilisation des unités de commande et de traitement de l'appareil d'imagerie par résonance magnétique de manière à exécuter les procédés de lecture de la ou des mesures, et/ou de calcul du ou des champs de bruit intérieurs et/ou de définition des au moins deux ou plus bandes de fréquence prédéterminées et/ou de génération des courants d'excitation du champ de compensation, une ou plusieurs bobines générant le ou les champs de compensation à l'intérieur du local dans lequel se situe l'appareil d'imagerie par résonance magnétique et des programmes commandant les unités de commande et de traitement de l'appareil d'imagerie par résonance magnétique de manière à exécuter les étapes du procédé de compensation de champ de bruit selon l'une quelconque ou plusieurs des revendications précédentes 1 à 18, étant fournies.

20. Procédé selon l'une quelconque ou plusieurs des revendications précédentes, **caractérisé en ce que** le volume d'espace dans lequel des champs de bruit sont compensés est la cavité qui reçoit le corps à examiner, ou une partie de celui-ci, de l'appareil d'imagerie par résonance magnétique.

21. Procédé selon la revendication 19 ou la revendication 20, **caractérisé en ce que** l'appareil d'imagerie par résonance magnétique est également un dispositif de mesure des champs magnétiques dans le volume d'espace pour exécuter les étapes du procédé selon l'une quelconque ou plusieurs des revendications 9 à 17, les unités d'entrée d'affichage et de commande et les unités de commande et de traitement de l'appareil d'imagerie par résonance magnétique étant commandées par des programmes chargés exécutant lesdites étapes selon l'une quelconque ou plusieurs des revendications 9 à 17.

22. Procédé selon l'une quelconque ou plusieurs des revendications précédentes, **caractérisé en ce qu'**il compense des pics ou des variations rapides des champs de bruit, qui sont modifiés par les courants générés dans les structures électriquement conductrices autour de la cavité magnétique, la courbe desdits champs de bruit étant mise en équation avec des fonctions de courbe de champ exponentielle, qui sont utilisées pour calculer des fonctions de courbe de champ de compensation exponentielle inverse, par conséquent les courants générant des champs de compensation pour des transitoires rapides du champ de bruit, lesquels courants peuvent être superposés ou combinés avec les courants générant les champs de compensation des champs de bruit qui présentent des variations dans une ou plusieurs bandes à basses fréquences.

23. Dispositif de compensation de champs de bruit magnétique dans un volume d'espace et de mise en application du procédé selon l'une quelconque ou plusieurs des revendications précédentes 1 à 22, qui comprend:
au moins une sonde de détection de champ de bruit (S1, S2, S3, S4, S5, S6), lesquelles sondes (S1, S2, S3, S4, S5, S6) sont disposées en dehors d'un volume d'espace (V) ;
au moins une unité (2) déterminant les champs magnétiques à l'intérieur du volume d'espace, sur la base des données détectées par la ou les sondes (S1, S2, S3, S4, S5, S6) et/ou des fonctions de calcul ou de corrélation définies de manière empirique ou théorique sur la base de l'électrodynamique ;
au moins une unité (3) générant les champs de compensation magnétique des champs de bruit à l'intérieur du volume d'espace (V),
**caractérisé en ce que**
ledit dispositif comprend en outre des moyens (4) définissant au moins une fréquence de séparation pour discriminer au moins deux bandes des champs de bruit, et des moyens (2) déterminant les champs magnétiques correspondants à l'intérieur du volume d'espace (V) et/ou des moyens (3) générant les champs de compensation correspondants, dont au moins certains sont différents pour au moins certains des champs de bruit desdites au moins deux bandes de fréquences.

24. Dispositif selon la revendication 23, **caractérisé en ce qu'**il comprend un ensemble de filtres (4) dont la bande passante est telle qu'elle divise une plage de fréquences en au moins deux bandes de fréquences différentes ou en trois bandes de fréquences ou plus.

25. Dispositif selon la revendication 23 ou la revendication 24, **caractérisé en ce que** des moyens (2) séparés et différents déterminant les champs de bruit magnétique à l'intérieur du volume (V), fonctionnant avec des fonctions au moins en partie différentes, sont prévus pour toutes les bandes de fréquences (4), ou pour certaines d'entre elles, des champs de bruit magnétique ou pour des sous-ensembles des bandes de fréquences.

26. Dispositif selon l'une quelconque ou plusieurs des revendications précédentes 23 à 25, **caractérisé en ce que**, en remplacement de ou en combinaison avec ce qui précède, des moyens (3) séparés et différents générant des champs de compensation sont prévus pour chaque bande de fréquences ou pour des sous-ensembles de bandes de fréquences.

27. Dispositif selon l'une quelconque ou plusieurs des revendications précédentes 23 à 26, **caractérisé en ce qu'**il présente une seule sonde (S1, S2, S3, S4, S5, S6) en dehors du volume d'espace, laquelle est connectée à une seule unité informatique (2) déterminant le champ de bruit à l'intérieur du volume d'espace (V) et à une seule unité (3) générant le champ de compensation.

28. Dispositif selon l'une quelconque ou plusieurs des revendications précédentes 23 à 27, **caractérisé en ce qu'**il présente une seule sonde (S1, S2, S3, S4, S5, S6) en dehors du volume d'espace (V), laquelle est connectée à une seule unité informatique (2) déterminant le champ de bruit à l'intérieur du volume d'espace (V), ladite unité informatique (2) étant connectée à une pluralité d'unités de générateurs (3) générant des champs de compensation, tous ou certains de ces derniers étant associés à l'une au moins des deux, trois ou plus, bandes de fréquences de champ de bruit prédéterminées, la sonde (S1, S2, S3, S4, S5, S6), qui est utilisée de manière successive, détectant des champs de bruit avec des fréquences dans la plage des au moins deux, trois ou plus, bandes de fréquences prédéterminées, des moyens (4) de filtrage de bande passante variable, ou des filtres différents (4) avec des bandes passantes différentes, pour une connexion alternée à la sonde (S1, S2, S3, S4, S5, S6) étant fournis, et l'unité informatique (2) déterminant les champs de bruit à l'intérieur du volume d'espace (V) étant programmable et dotée d'une unité de mémoire qui contient les différentes fonctions de calcul des champs de bruit à l'intérieur du volume d'espace (V), sur la base des champs de bruit détectés par la sonde (S1, S2, S3, S4, S5, S6) en dehors du volume d'espace (V), et pour une corrélation entre les champs de bruit en dehors du volume d'espace (V) et les champs correspondants à l'intérieur du volume d'espace (V), tandis que les algorithmes desdites fonctions de calcul et de corrélation pour déterminer et corréler les champs magnétiques à l'intérieur du volume d'espace (V), correspondant à toutes les bandes passantes du filtre (4) ou à certaines de celles-ci, sont chargés et exécutés dans la mémoire de travail, en synchronisme avec la détection des champs de bruit extérieurs dans la plage d'une bande correspondante parmi lesdites bandes de fréquences, tandis que les données de champ de bruit intérieur, telles qu'elles ont été déterminées de ce fait, sont transmises à un générateur (3) de champ de compensation dédié à la bande de fréquences correspondante.

29. Dispositif selon l'une quelconque ou plusieurs des revendications précédentes 23 à 26 et 27 ou 28, **caractérisé en ce qu'**il présente de multiples sondes permanentes (S1, S2, S3, S4, S5, S6), chacune d'elles étant dédiée à la détection de champs de bruit en dehors du volume d'espace (V), avec des fréquences dans la plage de l'une des bandes de fréquences prédéterminées ou un sous-ensemble des bandes de fréquences prédéterminées, une unité (2) de calcul ou de corrélation des champs de bruit intérieurs pour chaque bande de fréquences prédéterminées ou le sous-ensemble de bandes de fréquences prédéterminées, ainsi qu'une unité de générateur de champ de compensation pour chaque bande de fréquences ou chaque sous-ensemble de bandes de fréquences.

30. Dispositif selon l'une quelconque ou plusieurs des revendications précédentes 23 à 26 et 29, **caractérisé en ce que** la ou les unités (3) de génération de champ de compensation comprennent une unité électronique qui génère un courant destiné à actionner une ou plusieurs bobines (B1, B2, B3, B4 ; 13, 14, 15) de génération de champ magnétique, telles que des solénoïdes ou similaires, bien qu'il soit possible de fournir une seule bobine de génération de champ de compensation, qui est ou peut être connectée à toutes les différentes unités (3) ou à certaines d'entre elles, générant des courants d'excitation de champ de compensation des champs de bruit avec des fréquences dans la plage de deux au moins, trois ou plus, bandes de fréquences prédéterminées.

31. Dispositif selon l'une quelconque ou plusieurs des revendications précédentes 23 à 26 et 29 ou 30, **caractérisé en ce que** la ou les unités (3) de génération de champ de compensation comprennent une unité électronique qui génère un courant destiné à actionner une ou plusieurs bobines (B1, B2, B3, B4 ; 13, 14, 15) de génération de champ magnétique, telles que des solénoïdes ou similaires, bien qu'une bobine de génération de champ de compensation soit fournie pour toutes les unités (3) générant des courants d'excitation de champ de compensation ou pour des sous-ensembles de celles-ci, laquelle bobine est séparée et associée à au moins l'une des au moins deux, trois ou plus, bandes de fréquences prédéterminées, ou à un sous-ensemble desdites au moins deux, trois ou plus, bandes de fréquences.

32. Dispositif selon l'une quelconque ou plusieurs des revendications précédentes 23 à 26 et 29 à 31, **caractérisé en ce qu'**il présente au moins deux, trois ou plus, sondes (S1, S2, S3, S4, S5, S6), placées en dehors du volume d'espace (V) en différents endroits, et chacune d'elles étant conçue de manière à détecter le champ de bruit en dehors dudit volume d'espace (V) aux différents emplacements de sonde, avec des fréquences dans la plage d'au moins une bande de fréquence des au moins deux, trois ou plus, bandes prédéterminées, un algorithme étant chargé dans l'unité (2) de calcul et de corrélation, générant et résolvant un système d'équations de description de champ, chaque équation se composant d'une fonction de calcul ou de corrélation et d'une fonction de description de champ de bruit appliquées aux données détectées par l'une desdites au moins deux, trois ou plus, sondes (S1, S2, S3, S4, S5, S6), laquelle solution du système d'équations fournit tous les paramètres variables de description de champ de bruit.

33. Dispositif selon la revendication 32, **caractérisé en ce qu'**il comprend une unité de traitement programmable qui contient les programmes de résolution des systèmes d'équations.

34. Dispositif selon l'une quelconque ou plusieurs des revendications précédentes 32 et 33, **caractérisé en ce qu'**il comprend un nombre de sondes de mesure (S1, S2, S3, S4, S5, S6) qui correspond au nombre de paramètres variables indépendants de la fonction de description de champ de bruit.

35. Dispositif selon l'une quelconque ou plusieurs des revendications précédentes 23 à 26 et 29 à 34, **caractérisé en ce qu'**il comprend au moins une sonde ou un dispositif (5) qui mesure le champ à l'intérieur du volume d'espace (V), fournissant en cela des moyens (6) de comparaison du ou des champs de bruit à l'intérieur du volume d'espace qui sont obtenus par un calcul sur la base des champs extérieurs mesurés et des champs à l'intérieur du volume d'espace (V) qui sont mesurés par les sondes ou le dispositif internes (5), ainsi que des moyens (7, 9) réglant manuellement les paramètres des fonctions de calcul et de corrélation et/ou des champs de compensation, afin de minimiser les différences entre les champs intérieurs calculés et les champs intérieurs réellement mesurés.

36. Dispositif selon la revendication 35, **caractérisé en ce que** les sondes ou les dispositifs (5) situés à l'intérieur du volume d'espace sont des sondes ou des dispositifs actifs, à savoir qui génèrent un champ de test prédéterminé, dont les caractéristiques sont bien connues et prédéterminées dans un état sans bruit, tandis que le comparateur (6) reçoit les mesures dudit champ de test à l'intérieur du volume d'espace (V) et les valeurs nominales connues (8) dudit champ de test, des moyens (7, 8) réglant manuellement les paramètres des fonctions de calcul, corrélation, description de champ de bruit et génération de champ de compensation, afin de minimiser ou de neutraliser les différences entre les données de champ de test connu et les données de mesure de champ de test réelles, étant en cela fournis.

37. Dispositif selon l'une quelconque ou plusieurs des revendications précédentes 35 ou 34, **caractérisé en ce qu'**un dispositif d'excitation et de détection des échos de résonance magnétique dans un fantôme prédéterminé est utilisé en tant que dispositif de détection de champ intérieur.

38. Dispositif selon la revendication 37, **caractérisé en ce que** le dispositif de détection du champ à l'intérieur du volume d'espace (V) comprend des moyens (12) générant un champ statique à l'intérieur d'un volume prédéterminé, une bobine (13) transmettant des impulsions d'excitation de spin nucléaire, une bobine (16) recevant des échos en provenance desdits spins nucléaires, et un fantôme (F) présentant des caractéristiques de réponse bien connues associées auxdits échos de résonance magnétique, des moyens déterminant la fréquence desdits échos de résonance magnétique et des moyens (6) comparant ladite fréquence d'écho de résonance magnétique avec la fréquence bien connue, des moyens (7, 9) réglant les paramètres de la ou des fonctions de calcul ou de corrélation et/ou des fonctions de description de champ de bruit et/ou des générateurs de champ de compensation, afin de minimiser ou de neutraliser la différence qui résulte de la sortie du comparateur.

39. Dispositif selon l'une quelconque ou plusieurs des revendications précédentes 23 à 26 et 29 à 38, **caractérisé en ce qu'**il comprend des moyens de traitement des caractéristiques de champ statique réelles à partir des signaux d'écho reçus, les données réelles étant comparées avec les données nominales bien connues dans le comparateur.

40. Dispositif selon la revendication 39, **caractérisé en ce qu'**il comprend des moyens déterminant la distribution de champ de test statique au cours du temps, sur la base de la fréquence des signaux d'écho de résonance magnétique.

41. Dispositif selon l'une quelconque ou plusieurs des revendications précédentes 23 à 26 et 29 à 40, **caractérisé en ce qu'**il comprend des moyens effectuant automatiquement des réglages des paramètres des fonctions de calcul ou de corrélation et/ou de génération de courant d'excitation de champ de compensation, consistant en une unité de rétroaction qui règle les paramètres des fonctions de calcul ou de corrélation et/ou de la fonction de description de champ de bruit, et/ou les caractéristiques du courant de génération de champ de compensation sur la base du signal de différence qui résulte du comparateur (6) et en vue de minimiser ou de neutraliser lesdites différences.

42. Dispositif selon l'une quelconque ou plusieurs des revendications précédentes 23 à 26 et 29 à 41, **caractérisé en ce que** des moyens de réglage manuel peuvent être fournis en variante ou en association, à savoir des moyens d'entrée de commande réglant les paramètres des fonctions de calcul ou de corrélation et/ou les courants de génération de champ de compensation.

43. Dispositif selon l'une quelconque ou plusieurs des revendications précédentes 23 à 26 et 29 à 42, **caractérisé en ce qu'**il comprend des moyens (7) affichant les paramètres ou la courbe du champ de test et/ou des champs de bruit extérieurs et/ou des champs intérieurs à la fois théoriques ou connus et réels ou mesurés, lesquels moyens affichent lesdites données sous une forme alternée, superposée et/ou en mosaïque, des moyens (9) d'interface graphique des moyens d'entrée graphique grâce auxquels sont entrées des commandes qui modifient l'aspect des champs magnétiques et/ou des paramètres de ceux-ci et des moyens d'association univoque d'un réglage aux paramètres des fonctions de calcul et de corrélation et/ou aux courants de génération de champ de compensation en réponse aux modifications graphiques sélectionnées.

44. Dispositif selon l'une quelconque ou plusieurs des revendications précédentes 23 à 26 et 29 à 43, **caractérisé en ce que** les moyens et les unités du dispositif peuvent être des unités qui présentent une construction dédiée ou des ordinateurs, ainsi que des PC programmés de manière appropriée par messages électroniques, qui présentent des interfaces de connexion avec les sondes de mesure de champ de bruit extérieur et/ou de champ de bruit intérieur, et avec les bobines de génération de champ de compensation et/ou avec les dispositifs de génération et de mesure de champ de test, tandis que le logiciel exécutant les fonctions de lecture de signal de sonde, et/ou les algorithmes déterminant les fonctions de calcul et de corrélation de manière à déterminer les champs de bruit intérieurs, les algorithmes déterminant les fonctions de génération de courant pour créer les courants de génération de champ de compensation, les algorithmes exécutant les fonctions de comparaison, les fonctions de détermination automatique ou de réglage manuel des réglages sur les paramètres des fonctions de calcul et de corrélation et/ou sur les fonctions de génération de courant d'excitation de champ de compensation, ainsi que le logiciel affichant et commandant les interfaces d'entrée de données manuelles alphanumériques et graphiques, sont chargés dans ledit ordinateur ou PC selon n'importe quelle association ou association secondaire.

45. Dispositif selon l'une quelconque ou plusieurs des revendications précédentes 23 à 26 et 29 à 44, **caractérisé en ce qu'**il comprend des moyens déterminant, dans un temps donné, les valeurs maximum et minimum de la courbe de champ de bruit ; des moyens réglant ledit temps; des moyens déterminant la valeur moyenne, ou le décalage, du champ de bruit, et des moyens soustrayant ladite valeur moyenne ou ledit décalage de la courbe de champ de bruit de ce dernier, ainsi que des moyens générant le champ de compensation à partir de ladite courbe de champ de bruit après la soustraction de celui-ci de la valeur moyenne ou du décalage.

46. Dispositif selon l'une quelconque ou plusieurs des revendications précédentes 23 à 26 et 29 à 45, **caractérisé en ce qu'**il est fourni en association avec un appareil d'imagerie par résonance magnétique, qui est contenu dans un espace délimité, qui forme le volume d'espace (V), dans lequel les champs de bruit doivent être compensés au moins pour certaines des unités de fonctionnement de l'appareil de résonance magnétique utilisé de manière à exécuter au moins certaines des fonctions du dispositif selon l'une quelconque ou plusieurs des revendications précédentes 23 à 45, en association avec des programmes de commande qui peuvent être chargés dans l'unité de commande et de traitement dudit appareil d'imagerie par résonance magnétique.

47. Dispositif selon l'une quelconque ou plusieurs des revendications précédentes 23 à 26 et 29 à 46, **caractérisé en ce qu'**un appareil de résonance magnétique est utilisé en tant que sonde interne détectant les conditions du champ magnétique à l'intérieur dudit espace (V) sur la base des changements apportés à un champ statique bien connu.

48. Dispositif selon l'une quelconque ou plusieurs des revendications précédentes 23 à 26 et 29 à 47, **caractérisé en ce que** la partie d'affichage et de traitement graphique de l'appareil d'imagerie par résonance magnétique est utilisée en tant qu'unité d'affichage et de traitement graphique de manière à afficher la courbe du champ magnétique de test telle qu'elle est obtenue par une mesure réelle, et celle associée à des caractéristiques connues et prédéterminées, et à procéder aux réglages appropriés de manière à minimiser ou à neutraliser les différences entre le champ de test réel et le champ de test qui présente ces caractéristiques connues et prédéterminées, à savoir le champ de test nominal.

49. Appareil d'imagerie par résonance magnétique qui présente une cavité recevant un corps à examiner ou une partie de celui-ci, **caractérisé en ce qu'**il est d'une pièce avec un dispositif compensant les champs de bruit dans ladite cavité (V) ;
ledit dispositif, compensant les champs de bruit magnétique dans un volume d'espace et mettant en application le procédé selon l'une quelconque ou plusieurs des revendications précédentes 1 à 22, comprend :
au moins une sonde (S1, S2, S3, S4, S5, S6) de détection de champ de bruit, lesquelles sondes (S1, S2, S3, S4, S5, S6) sont disposées en dehors d'un volume d'espace (V) ;
au moins une unité (2) déterminant les champs magnétiques à l'intérieur du volume d'espace, sur la base des données détectées par la ou les sondes (S1, S2, S3, S4, S5, S6) et/ou des fonctions de calcul ou de corrélation définies de manière empirique ou théorique sur la base de l'électrodynamique ;
au moins une unité (3) générant les champs de compensation magnétique des champs de bruit à l'intérieur du volume d'espace (V) ;
ledit dispositif comprend en outre des moyens (4) définissant au moins une fréquence de séparation de manière à discriminer au moins deux bandes des champs de bruit, et des moyens (2) déterminant les champs magnétiques correspondants à l'intérieur du volume d'espace (V) et/ou des moyens (3) générant les champs de compensation correspondants, dont au moins certains sont différents pour au moins certains des champs de bruit desdites au moins deux bandes de fréquences.

50. Appareil selon la revendication 49, **caractérisé en ce que** le dispositif compensant les champs de bruit à l'intérieur de la cavité qui reçoit le corps à examiner ou la partie de celui-ci présente des caractéristiques selon l'une quelconque ou plusieurs des revendications précédentes 24 à 49.

51. Appareil d'imagerie par résonance magnétique selon la revendication 49 ou la revendication 50, **caractérisé en ce qu'**il présente une cavité (V) recevant un corps à examiner ou une partie de celui-ci, des moyens (12) générant un champ statique qui emplit ladite cavité, au moins une bobine (15) de transmission d'impulsion d'excitation, au moins une bobine (16) de réception d'écho de spin nucléaire, au moins une bobine (13) de compensation de champ statique et au moins une bobine (14) de gradient, et **en ce qu'**il est fourni une unité (10) de commande d'appareil électronique destinée à actionner la bobine de transmission, la bobine de compensation et la ou les bobines de gradient, et qui reçoit des signaux d'écho de spin nucléaire en provenance de la bobine de réception, les traite et affiche les images correspondantes, lequel appareil présente, d'une pièce avec celui-ci, un dispositif compensant les champs de bruit à l'intérieur de la cavité (V) qui reçoit le corps à examiner ou une partie de celui-ci, fournissant en cela au moins une sonde (S1, S2, S3, S4, S5, S6) détectant lesdits champs de bruit à l'intérieur de ladite cavité (V), des moyens (2) déterminant lesdits champs de bruit à l'intérieur de ladite cavité (V) sur la base des mesures extérieures, par des fonctions de calcul ou de corrélation ou de description de champ de bruit définies de manière théorique ou empirique, des moyens (3) générant les champs de compensation desdits champs de bruit à l'intérieur de ladite cavité (V).

52. Appareil selon la revendication 51, **caractérisé en ce que** lesdits moyens (2) déterminant lesdits champs de bruit à l'intérieur de ladite cavité (V) sur la base des mesures extérieures, par des fonctions de calcul ou de corrélation ou de description de champ de bruit définies de manière théorique ou empirique, et lesdits moyens (3) générant les champs de compensation des champs de bruit à l'intérieur de ladite cavité (V) sont des unités séparées, différentes des unités (10) de commande et de traitement spécifiques de l'appareil d'imagerie par résonance magnétique, ou certaines d'entre elles, voire toutes (2, 3) sont des unités existantes de l'appareil d'imagerie magnétique nucléaire, en association avec des programmes de commande spécifiques pour actionner les unités de l'appareil d'imagerie par résonance magnétique, comme lesdits moyens (2) déterminant lesdits champs de bruit à l'intérieur de ladite cavité (V) et/ou lesdits moyens (3) générant les champs de compensation des champs de bruit à l'intérieur de ladite cavité (V).

53. Appareil selon la revendication 52, **caractérisé en ce que** les moyens de génération de champ de compensation comprennent la ou les bobines (13) de compensation et/ou la ou les bobines (14) de gradient.

54. Appareil selon l'une quelconque ou plusieurs des revendications précédentes 49 à 53, **caractérisé en ce qu'**il comporte une unité (10) de commande et de traitement programmable et **en ce que** tous les moyens du dispositif de compensation de champ de bruit sont des unités électroniques de l'appareil d'imagerie par résonance magnétique, en association avec un logiciel exécutant les fonctions de mesure et de détermination du champ de bruit et du champ de compensation.

55. Appareil selon l'une quelconque ou plusieurs des revendications précédentes 49 à 54, **caractérisé en ce qu'**il présente une entrée pour au moins une sonde, de préférence pour au moins deux, trois ou plus, sondes (S1, S2, S3, S4, S5, S6) détectant des champs en dehors de la cavité (V) qui reçoit le corps à examiner, et des unités interfaçant lesdites sondes avec l'unité (10) de commande et de traitement de l'appareil, alors qu'un programme exécutant le procédé de compensation est chargé, qui détermine, en utilisant des fonctions de calcul et de corrélation établies au préalable, le champ de bruit à l'intérieur de la cavité (V) et le courant d'excitation de la bobine (13) de compensation et/ou de la bobine (14) de gradient, à superposer aux courants (17, 18) générant les champs de compensation et/ou de gradient normaux de manière à obtenir des champs de compensation de champ de bruit.

56. Appareil selon l'une quelconque ou plusieurs des revendications précédentes 49 à 55, **caractérisé en ce qu'**il comprend une interface de connexion avec une ou plusieurs sondes (S1, S2, S3, S4, S5, S6), laquelle interface présente des moyens (4) réglant des seuils de fréquence, de manière à déterminer au moins deux bandes de fréquences différentes des champs de bruit ou des filtres qui présentent une bande passante qui peut être ou qui est réglée sur des bandes de fréquences différentes pour une mesure séparée des champs de bruit qui présentent des fréquences différentes.

57. Appareil selon l'une quelconque ou plusieurs des revendications précédentes 49 à 56, **caractérisé en ce qu'**il comporte des unités matérielles individuelles ou des programmes informatiques spécifiques chargés dans l'unité de commande et de traitement de celui-ci, des unités informatiques séparées (2) déterminant les champs de bruit à l'intérieur de la cavité (V) en utilisant des fonctions de calcul ou de corrélation optimisées pour chaque bande de fréquences des au moins deux bandes de fréquences utilisées.

58. Appareil selon l'une quelconque ou plusieurs des revendications précédentes 49 à 57, **caractérisé en ce qu'**il comporte des unités matérielles individuelles ou des programmes informatiques spécifiques chargés dans l'unité de commande et de traitement de celui-ci, des unités (3) de génération séparées générant les champs de compensation des champs de bruit à l'intérieur de la cavité (V) pour chaque bande de fréquences des au moins deux bandes de fréquences utilisées.

59. Appareil selon l'une quelconque ou plusieurs des revendications précédentes 49 à 58, **caractérisé en ce que** les unités séparées (3), générant les champs de compensation des champs de bruit à l'intérieur de la cavité (V) pour chaque bande de fréquence des au moins deux bandes de fréquences utilisées, se composent d'une seule unité de générateur qui génère les courants d'excitation d'une seule bobine de compensation, ou de multiples unités (3) de générateur séparées pour chaque bande de fréquence en service, qui actionnent les bobines (13, 14) de génération de champ de compensation, de manière individuelle ou dans des ensembles séparés.

60. Appareil selon l'une quelconque ou plusieurs des revendications précédentes 49 à 59, **caractérisé en ce que** les unités (3) de génération, qui génèrent des courants d'excitation de champs de compensation en grande partie homogènes ou uniformes, au moins à l'intérieur de la cavité d'imagerie (V), actionnent les bobines (13) de compensation de champ statique de l'appareil d'imagerie par résonance magnétique, tandis que des unités de génération sont fournies afin de compenser les champs de bruit non homogènes ou non uniformes dans ladite cavité d'imagerie (V), qui actionnent les bobines (14) de gradient ou règlent les courants d'excitation de bobine de gradient afin de générer des champs de compensation desdits champs de bruit non homogènes ou non uniformes.

61. Appareil selon l'une quelconque ou plusieurs des revendications précédentes 49 à 60, **caractérisé en ce qu'**il comprend des moyens mesurant le champ magnétique réel à l'intérieur de la cavité, qui comprennent des générateurs (12) de champ statique, une ou des bobines (15) de transmission d'impulsion d'excitation, des bobines (16) de réception d'écho de spin nucléaire, ainsi que l'unité (10) de commande et de traitement de l'appareil lui-même, en cela fournissant un fantôme (F) destiné à être reçu dans la cavité (V) de l'appareil et un programme informatique mesurant le champ réel dans la cavité, lequel programme est chargé et peut être exécuté par l'unité (10) de commande et de traitement, et comprend les étapes consistant à transmettre des impulsions d'excitation au fantôme dans la cavité, à recevoir des échos de spin en provenance du fantôme, à déterminer la courbe de champ à l'intérieur de la cavité à partir des échos reçus, et à comparer la fréquence d'écho reçue et/ou la courbe de champ intérieur réelle avec la fréquence d'écho attendue de manière nominale ou théorique et/ou avec la courbe de champ statique attendue de manière nominale ou théorique.

62. Appareil selon la revendication 61, **caractérisé en ce qu'**il comprend des unités matérielles dédiées ou des programmes informatiques chargés dans l'unité (10) de commande et de traitement traitant de manière automatique ou manuelle des signaux de correction afin de corriger les fonctions de calcul de champ de bruit intérieur sur la base des détections exécutées par la ou les sondes en dehors de la cavité et/ou de corriger les courants d'excitation du ou des champs de compensation.

63. Appareil selon la revendication 62, **caractérisé en ce qu'**il comprend des moyens affichant graphiquement la courbe du champ mesuré et/ou du champ connu, et des moyens (9) d'entrée manuelle destinés à entrer des paramètres de correction de manière alphanumérique ou par l'intermédiaire de dispositifs graphiques réglant la courbe réelle du champ affiché, lesquels paramètres sont interprétés par l'appareil et transformés en signaux de commande appropriés, en cela fournissant des unités matérielles dédiées ou des programmes informatiques appropriés dans l'unité (10) de commande et de traitement de l'appareil.

64. Appareil selon l'une quelconque ou plusieurs des revendications précédentes 49 à 63, **caractérisé en ce qu'**il comprend des moyens déterminant, dans un temps donné, les valeurs maximum et minimum de la courbe de champ de bruit ; des moyens réglant ledit temps ; des moyens déterminant la valeur moyenne, ou le décalage, du champ de bruit, et des moyens soustrayant ladite valeur moyenne ou ledit décalage de la courbe de champ de bruit de ce dernier, ainsi que des moyens générant le champ de compensation à partir de ladite courbe de champ de bruit après la soustraction de celui-ci de la valeur moyenne ou du décalage.
